(19) Europäisches Patentamt
European Patent Office
Office européen des brevets

(11) EP 0 240 309 B1

(12) # EUROPEAN PATENT SPECIFICATION

(45) Date of publication and mention of the grant of the patent:
**28.08.1996 Bulletin 1996/35**

(51) Int Cl.⁶: **H01L 21/20**, C30B 25/04, C30B 23/04

(21) Application number: **87302788.2**

(22) Date of filing: **31.03.1987**

(54) **Method for forming crystal and crystal article obtained by said method**

Herstellungsverfahren eines Kristalls und so hergestellter Kristall

Méthode de fabrication d'un cristal et cristal ainsi produit

(84) Designated Contracting States:
**AT BE CH DE ES FR GB GR IT LI LU NL SE**

(30) Priority: **31.03.1986 JP 73093/86**
**20.03.1987 JP 67335/87**

(43) Date of publication of application:
**07.10.1987 Bulletin 1987/41**

(73) Proprietor: **CANON KABUSHIKI KAISHA**
**Tokyo (JP)**

(72) Inventors:
- **Matsuyam, Jinsho**
  **Nagahama-shi Shiga-ken (JP)**
- **Hirai, Yutaka**
  **Hikone-shi Shiga-ken (JP)**
- **Ueki, Masao**
  **Urayasu-shi Chiba-ken (JP)**
- **Sakai, Akira**
  **Nagahama-shi Shiga-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 244 081** **US-A- 4 239 788**

- **PATENT ABSTRACTS OF JAPAN, vol. 8, no. 172 (C-237)[1609], 9th August 1984; & JP-A-59 69 495**
- **SOLID STATE TECHNOLOGY, vol. 27, no. 9, September 1984, pages 239-243, Port Washington, New York, US; L. JASTRZEBSKI: "Silicon CVD for SOI: Principles and possible applications"**
- **JOURNAL OF THE ELECTROCHEMICAL SOCIETY, vol. 129, no. 10, October 1982, pages 2303-2306, Manchester, New Hampshire, US; D.D. RATHMAN et al.: "Lateral epitaxial overgrowth of silicon on SiO2"**
- **BRITISH JOURNAL OF APPLIED PHYSICS, vol. 18, no. 10, October 1967, pages 1357-1382, GB; J.D. FILBY et al.: "Single-crystal films of silicon on insulators"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

This invention relates to a method for producing on the surface of a substrate one or more single crystals and to an article produced by said method. This method which comprises the features claimed in the pre-characterising part of claim 1 is known from US-A-3620833.

The present invention can be used to form a crystalline deposited film which may be a single crystal film or a polycrystalline film and which may be used in electronic devices, optical devices, magnetic devices, piezoelectric devices or surface acoustic devices etc. Such devices may include semiconductor integrated circuits, optical integrated circuits, magnetic circuits etc.

In the prior art, single crystal films to be used for semiconductor electronic devices or optical devices have been formed by epitaxial growth on a single crystal substrate. For example, it has been known that epitaxial growth of Si, Ge, GaAs, etc can be carried out from the liquid phase, from the gas phase, or from the solid phase on a Si single crystal substrate (silicon wafer). It is also known that epitaxial growth of a single crystal such as GaAs, GaAlAs etc occurs on a GaAs single crystal substrate. Using a semiconductor thin film formed in this way, semiconductor devices and integrated circuits, and electroluminescent devices such as semiconductor lasers or LEDS have been prepared.

Recently extensive research has been carried out concerning ultra high speed transistors using a two-dimensional electronic gas, and concerning ultra-lattice devices using a quantum well etc. These devices have been made possible by high precision epitaxial techniques such as MBE (molecular beam epitaxy) or MOCVD (organometallic chemical vapour deposition) using an ultra-high vacuum.

In epitaxial growth on a single crystal substrate, it is necessary to match the lattice constants and coefficients of thermal expansion between the single crystal material of the substrate and the epitaxial growth layer. For example, it is possible to effect epitaxial growth of Si single crystal thin film on sapphire which is an insulating single crystal substrate. However, crystal lattice defects at the interface due to differences in lattice constants and diffusion of aluminium which is a component of sapphire into the epitaxial layer pose problems in the application of this process to electronic devices or circuits. Furthermore, the formation of a single crystal thin film by epitaxial growth is highly dependent upon the material of the substrate used.

Mathews et al have discussed combinations of subject material and epitaxial growth layer (Epitaxial Growth, Academic Press, New York 1975, ed. by J. W. Mathews). Only an extremely narrow range of materials are suitable for use as the substrate in the methods of the prior art. Wafers of Si are available in sizes of about 15cm (6 inches) and GaAs substrates are available in lesser sizes. Furthermore the need to use a single crystal substrate increases production cost and hence the cost per chip.

Extensive research has also been carried out in recent years concerning three-dimensional integrated circuits in which semiconductor devices extending in the normal direction of the substrate are laminated one on the other to increase the degree of integration and to provide multi-functionality. Research has also been carried out concerning large area semiconductor devices in which individual devices are arranged in an array on an inexpensive glass substrate. Such devices are becoming more abundant from year to year and examples include solar batteries and switching transistors of liquid crystal picture elements.

A common feature of both of these techniques is the need to provide a semiconductor thin film on an amorphous insulating material and subsequently form electronic devices such as transistors etc thereon. There is, in particular, a requirement to be able to form a single crystal semiconductor of high quality on an amorphous insulating material.

Generally speaking, when a thin film is deposited on a substrate which is an amorphous insulating material such as $SiO_2$ etc, the deposited film has an amorphous or polycrystalline structure due to defects in the long distance order of the substrate material. An amorphous film is in a state in which local order between the closest atoms is preserved, but no longer distance order exists. In a polycrystalline film single crystal grains are present but, as is apparent from the boundaries which separate the grains, there is no specific crystal direction. For example, in the case of forming Si on $SiO_2$ by the CVD method, if the deposition temperature is about 600°C or lower the product film is of amorphous silicon while polycrystalline silicon with a distribution of grain sizes between some hundred and some thousand Å (1A = 0.1 nm) is formed above that temperature. The grain sizes of the polycrystalline silicon and the distribution thereof vary greatly depending upon the method of formation of the silicon. Furthermore, by melting and solidifying an amorphous or polycrystalline film by a beam of energy e.g. from a laser or a rod-shaped heater etc a polycrystalline thin film has been obtained whose grain size is some microns or millimetres (Single Crystal Silicon on Non-Single Crystal insulator, Journal of Crystal Growth, Vol 63, No 3, October 1983 edited by G. W. Cullen).

When a transistor is formed on a thin film made by the methods described above and having the resulting crystal structures and the electron mobility is measured, a mobility of about 0.1 $cm^2/V.sec$ or less is obtained for amorphous silicon, a mobility of 1 to 10 $cm^2/V.sec$ for polycrystalline silicon having grain sizes of some 100 Å and a mobility similar to that of single crystalline silicon for polycrystalline silicon which has been melted and solidified to produce large grain sizes. From these results it can be understood that there is a great difference in electrical properties between a device formed in a single crystal region within a crystal grain and device formed so as to bridge across a grain boundary. In other words, the deposited film on the amorphous material obtained in the prior art has an amorphous or polycrystalline structure in which there is a distribution of grain sizes, and devices formed thereon have greatly inferior performance compared with the devices prepared on a single crystal layer. For this reason, films deposited on polycrystalline or amorphous material can only be used to make simple switching devices, solar batteries, photoelectric converting devices, etc.

On the other hand, the method in which melting and solidification are used to form polycrystalline thin film of large grain size suffers from the problems that an enormous process time is required due to the need to scan the amorphous or single crystal thin film of every wafer with an energy beam, which gives poor productivity and also that the method is unsuitable for the treatment of large areas.

Furthermore in recent years studies of diamond thin film growth have become popular. Diamond thin film is a semiconductor having the particularly broad band gap of 5.5 eV and has a higher working temperature (about 500°C or less) than Si, Ge, GaAs etc which are established semiconductor materials. Also, the carrier mobility of both electrons and positive holes surpasses that of Si ($1800cm^2$/v.sec for electrons, $1600cm^2$/V.sec for positive holes) and thermal conductivity is also extremely high. For this reason diamond thin film is considered to be a promising material for high power semiconductor devices in which large quantities of heat are generated. However, although there have been reports in the prior art about epitaxial growth of diamond thin film on a diamond substrate by vapour phase growth (N. Pujimoto, T. Imai and A. Doi, Pro. of Int. Conf. IPAT), there has been no successful report about heteroepitaxial growth on a substrate other than an diamond substrate.

Generally speaking, diamond nuclei are generated using excitation with microwaves using a hydrocarbon type gas such as $CH_4$ etc and by irradiation with a hot filament or electron beam. However, the nucleation density is generally low so that it is difficult to obtain a continuous thin film. Even where a continuous film is formed, it has a polycrystalline structure with a large grain size distribution and it is difficult to use in semiconductor devices. Also if a diamond structure is required, the substrate is self-evidently expensive which also presents problems in enlarging the area of the film which can be produced. Therefore the use of diamond substrates is impractical.

It is apparent from the foregoing that there has been up to now no practical, easy and inexpensive way of making single crystal and polycrystal films on which devices of good electrical characteristics can be formed and which permits greater film areas or three-dimensional integration.

## SUMMARY OF THE INVENTION

A main object of the present invention is to provide a method for forming a crystal which has overcome the problems of the prior art as described above and a crystal article obtained by said method.

Another object of the present invention is to provide a method for forming a crystal of good quality such as single crystal containing no grain boundary or a polycrystal controlled in grain boundary, etc., without restriction with respect to the base materials, for example, without restriction with respect to materials, constitutions, sizes, etc., of the substrate, and a crystal article having the crystal obtained by said method.

Still another object of the present invention is to provide a method for forming the above crystal with good efficiency according to simple steps without use of a special device.

The above technical problem is solved by the method as claimed in Claim 1

Still another object of the present invention is to provide a crystal article having a single crystal which is grown singly on a nucleation surface ($S_{NDL}$), which nucleation surface ($S_{NDL}$) is formed at a concavity on a crystal forming surface with a material having sufficiently greater nucleation density (ND) than the material forming said crystal forming surface and has a sufficiently small area to the extent that only a single nucleus can be grown.

Still another object of the present invention is to provide a method for forming a crystal by utilizing the difference in nucleation density of the crystal forming materials according to the kinds of the materials forming the crystal forming surface, which comprises forming at a concavity on said crystal forming surface a nucleation surface ($S_{NDL}$) with a material having sufficiently greater nucleation density than the material forming said crystal forming surface having a sufficiently small area so that only a single nucleus may grow thereon, forming only a single nucleus on said nucleation surface ($S_{NDL}$), and growing a single crystal from said single nucleus, thereby forming a crystal.

Still another object of the present invention is to provide a method for forming cyrstal, which comprises applying a crystal forming treatment on a substrate having a free surface comprising a nonnucleation surface ($S_{NDS}$) with a small nucleation density and a nucleation surface ($S_{NDL}$) exposed from said nonnucleation surface, having a sufficiently small area for a crystal growing only from a single nucleus and having a greater nucleation density ($ND_L$) than the nucleation density ($ND_S$) of said nonnucleation surface ($S_{NDS}$), thereby growing a single crystal from said single nucleus.

Still another object of the present invention is to provide a method for forming a crystal, which comprises forming a nucleation surface ($S_{NDL}$) at a desired site of a base substrate surface with large nucleation density exposed as a small area for a crystal to grow from only a single nucleus by providing onto said base substrate surface a nonnucleation surface ($S_{NDS}$) having smaller nucleation density ($ND_S$) than the nucleation density ($ND_L$) of said nucleation surface ($S_{NDL}$) by addition of a material ($N_S$) for forming said nonnucleation surface ($S_{NDS}$) which is different from the mateiral ($M_L$) forming said nucleation surface ($S_{NDL}$) to obtain a substrate, and then applying a crystal forming treatment on said substrate to form a single crystal nucleus on said nucleation surface ($S_{NDL}$), thereby growing a single crystal from said single nucleus.

Still another object of the present invention is to provide a method for forming a crystal, which comprises applying a crystal forming treatment on a substrate having two kinds of crystal formation surfaces with a sufficiently great nucleation density difference ($\Delta$ND), of which the nucleation surface ($S_{NDL}$) with greater nucleation density is exposed from the nonnucleation surface ($S_{NDS}$) with smaller nucleation density and has a sufficiently small area for a single crystal growing from only a single nucleus to form a stable single nucleus on said nucleation surface ($S_{NDL}$) , thereby growing a single crystal from said single nucleus.

Still another object of the present invention is to provide a crystal article, comprising a substrate having a nonnucleation surface ($S_{NDS}$) with small nucleation density and a nucleation surface ($S_{NDL}$), arranged as underlying said nonnucleation surface ($S_{NDS}$), having a sufficiently small area for a crystal growing from only a single nucleus and having greater nucleation density ($ND_L$) than the nucleation density ($ND_S$) , and a single crystal which grows from said single nucleus and covers excessively over said nucleation surface ($S_{NDL}$).

## BREIF DESCRIPTION OF THE DRAWINGS

Fig. 1 is a graph for illustration of the relationship between the size of nucleus rc and free energy G in the process of forming thin film;
Figs. 2A and 2B are illustrations of the selective deposition method;
Fig. 3 is a graph showing the change with lapse of time of nucleation density (ND) on the deposition surface of $SiO_2$ and the deposition surface of silicon nitride;
Figs. 4A to 4D are illustrations of the formation steps showing a first embodiment of the method for forming crystal according to the present invention;
Figs. 5A and 5B are perspective views of the substrate in Figs. 4A and 4D;
Figs. 6A to 6D are illustrations of the steps for forming crystal showing a second embodiment of the present invention;
Figs. 7A to 7D are illustrations of the formation steps showing a third embodiment of the method for forming single crystal according to the present invention;
Figs. 8A and 8B are perspective views of the substrates in Figs. 7A and 7D;
Figs. 9A to 9C are illustrations of the steps for forming crystal showing a fourth embodiment of the present invention;
Figs. 10A and 10B are perspective views of the substrates in Figs. 9A and 9C;
Fig. 11 is a schematic sectional view showing an example of the multi-layer structure by use of the first embodiment of the present invention;
Figs. 12A to 12D are illustrations of the steps for forming crystal showing an eighth embodiment of the present invention;
Fig. 13 is a graph showing the relationship between the flow rate of $SiH_4$ and $NH_3$ and the composition ratio of Si and N in the silicon nitride film formed;
Fig. 14 is a graph showing the relationship between Si/N composition ratio and nucleation density;
Fig. 15 is a graph showing the time dependency of nucleation density of diamond nuclei on Fe, Co, Si and Mo.

## DETAILED DESCRIPTION OF THE PREFERRED EMBODIMENTS

For better understanding of the present invention, first the general process for forming a thin film of metal for semiconductor is explained.

When the deposition surface is made of a material different in kind from the flying atom, particularly an amorphous material, the flying atoms are diffused freely on the substrate surface, or again evaporated (released). And, as the result of collision mutually between the atoms, a nucleus is formed and when its size becomes the size rc (= -2 $^{\sigma}$o/gv) at which its free energy G becomes the maximum (critical nucleus), G is reduced and the nucleus continues to grow stably three-dimensionally to become shaped in an island. The nucleus with the size exceeding rc is called "stable nucleus", and unless otherwise particularly noted, "nucleus" in the following basic description of the present invention refers to this "stable nucleus". Also, among "stable nucleus", those with small r are called "initial nucleus".

The free energy generated by formation of nucleus is represented as follows:

$$G = 4\pi f(\theta)(\sigma_o r^2 + 1/3 \cdot gv \cdot r^3) \quad f(\theta) = 1/4 (2 - 3\cos\theta + \cos^2 \theta)$$

wherein,

r: radius curvature of nucleus
θ: contact angle of nucleus
gv: free energy per unit deposition
$\sigma_o$: surface energy between nucleus and vaccuum.

Fig. 1 shows the manner in which free energy G is changed. In the same Figure, the radius of curvature of the stable nucleus when free energy G is at the maximum value is rc.

Thus, nuclei grow to become shaped in islands, and further grow whereby contact mutally between islands progresses until sometimes coalescence occurs and via a network structure, it becomes finally a continuous film to cover completely over the substrate surface. Following such a process, a thin film is deposited on the surbstrate.

In the deposition process as described above, the density of nucleus formed per unit area of the substrate surface, the size of nucleus and the nucleation speed are determined depending on the state of the system of deposition, and particularly the interaction between the flying atoms and the substrate surface material is an important factor. Also, a specific crystal direction grows in parallel to the substrate due to anisotropy relative to the crystal surface of the interface energy at the interface between the deposited material and the substrate, and when the substrate is amorphous, the crystal direction within the substrate plane is not constant. For this reason, grain boundaries are formed by collision mutually between nuclei or islands, and particularly in the case of collision mutually between islands with some sizes or greater, grain boundaries are formed as such upon occurrence of coalescence. Since the grain boundaries formed are difficultly movable in the solid phase, the grain sizes are determined at that point.

Next, the selective deposition method for forming a deposited film selectively on the deposition surface is to be described. The selective deposition method is a method in which a thin film is formed selectively on the substrate by utilizing the differences between the materials in factors influencing nucleus formation in the thin film forming process such as surface energy, attachment coefficient, release coefficient, surface diffusion speed, etc.

Figs. 2A and 2B are illustrations of the selective deposition method. First, as shown in Figure 2A, on the substrate 1, a thin film 2 comprising a material different in the above factors from the substrate 1 is formed at a desired portion. And, when deposition of a thin film comprising an appropriate material is effected under appropriate deposition conditions, a thin film 3 grows only on the thin film 2, whereby it is possible to give rise to a phenomenon that no growth occurs on the substrate 1. By utilizing this phenomenon, the thin film 3 formed self-matchingly can be grown, whereby it becomes possible to omit the lithographic step by use of a resist as practiced in the prior art.

As the material for enabling deposition according to such selective formation method, for example, $SiO_2$ may be used as the substrate 1, Si, GaAs, silicon nitride as the thin film 2 and Si, W, GaAs, InP, etc., as the thin film 3 to be deposited.

Fig. 3 is a graph showing the change with lapse of time of nucleation density (ND) on the deposited surface of $SiO_2$ and the deposited surface of silicon nitride.

As shown in the same graph, soon after initiation of deposition, the nucleation density (ND) on $SiO_2$ is saturated at $10^3$ $cm^{-2}$ or less, and the value is not substantially changed even after 20 minutes.

In contrast, on silicon nitride ($Si_3N_4$), it is once saturated at about $4 \times 10^5$ $cm^{-2}$ or less, is not substantially changed 10 minutes thereafter, but is abruptly increased thereafter. This measurement example shows the case in which $SiCl_4$ gas is diluted with $H_2$ and deposited according to the CVD method under the conditions of a pressure of 170 Torr and a temperature of 1000 °C. Otherwise, the same action can be obtained by use of $SiH_4$, $SiH_2Cl_2$, $SiHCl_3$, $SiF_4$, etc., as the reaction gas, and controlling the pressure, temperature, etc. Also, the vacuum vapor deposition can be employed.

In this case, nucleation on $SiO_2$ poses substantially no problem, but by addition of HCl gas into the reaction gas, nucleation on $SiO_2$ can be further suppressed to make deposition of Si on $SiO_2$ perfectly zero.

Such a phenomenon depends greatly on the difference in adsorption coefficient, release coefficient, surface diffusion coefficient, etc., relative to Si of the material surfaces of $SiO_2$ and silicon nitride, but the fact that $SiO_2$ itself is etched by the reaction of $SiO_2$ with Si atom itself to form silicon monooxide with higher vapor pressure, while no such etching phenomenon occurs on silicon nitride may be also considered to be a cause to effect selective deposition (T. Yonehara, S. Yoshioka, S. Miyazawa, Journal of Applied Physics 53, 6839, 1982).

Thus, by selecting $SiO_2$ and silicon nitride as the materials of the deposition surface and silicon as the material to be deposited, sufficiently great nucleation density difference (ΔND) as shown in the same graph can be obtained. Here, although $SiO_2$ is desirable as the material for the deposition surface, this is not limitative and sufficiently practical nucleation density difference (ΔND) can be obtained even by use of $SiO_x$ $(0 < x < 2)$.

Of course, the present invention is not limited to these materials, but the difference in nucleation density (ΔND) may be sufficiently $10^3$-fold or more in density of nuclei as shown by the same graph, and sufficient selective formation of deposited film can be done with the materials as exemplified below.

As another method for obtaining this nucleation density difference (ΔND), for example, a thin film of silicon nitride

such as SiN, $Si_3N_4$, etc., which is a material ($M_L$) with greater nucleation density relative to Si on an appropriate base substrate, subsequently $SiO_2$ thin film is formed on said silicon nitride thin film and thereafter said $SiO_2$ thin film is removed locally with a desired size, thereby forming a region in which the silicon nitride thin film is exposed.

As still another method for obtaining this nucleation density diferrence ($\Delta$ND), for example, after a $Si_3N_4$ thin film is uniformly provided on the surface of an appropriate base substrate, a $SiO_2$ thin film may be formed selectively on said $Si_3N_4$ thin film so that exposed portions of the $Si_3N_4$ thin film may be provided locally.

The present invention utilizes selective deposition based on such nucleation density difference ($\Delta$ND) and, by forming a sufficiently minute region of a different kind of material having sufficiently greater nucleation density than the material of the deposition surface so that a single nucleus may grow on the region, a single crystal is to be grown selectively only at the site where such fine different kind of material exists.

In this connection, since selective growth of a single crystal is determined depending on the electron state of the crystal formation surface, particularly the state of dangling bonds, the material with higher nucleation density (for example, $Si_3N_4$ is not required to be a bulk material, but it may also be formed as a thin film on the surface of base plate of any desired material to form the above crystal formation surface.

In the following, the present invention is described in detail by referring to the drawings.

Figs. 4(A)-4(D) are illustrations of the formation steps showing a first embodiment of the method for forming crystal according to the present invention, and Figs. 5(A) and 5(B) are perspective views corresponding to Figs. 4(A) and 4(D).

First, as shown in Fig. 4(A) and Fig. 5(A), on the base substrate 4 is formed a thin film 6 (or called "Seed") [forming nucleation surface ($S_{NDL}$) 6A] with greater nucleation density enabling selective nucleation, on which a material different from the material forming the thin film 6 with greater nucleation density is thinly deposited, followed by patterning according to lithography, etc., to form a thin film 5 comprising a different material and forming nonnucleation surface ($S_{NDS}$) 5A so as to provide sufficiently finely nucleation surfaces ($S_{NDL}$) 6A. However, the size, the crystal structure and composition of the base substrate 4 may be chosen as desired, and it may be also a substrate having a functional device prepared according to conventional semiconductor technique formed thereon. Also, the nucleation surface ($S_{NDL}$) 6A comprising a different material may be also formed as a modified region containing excessive Si or N, which may be formed by forming a thin film 6 beneath the $SiO_2$ thin film 5 of a polycrystalline silicon or $SiO_2$, and injecting ions of Si or N into the exposed portions 6A.

Next, by selection of appropriate deposition conditions, a single nucleus of crystal formation material is formed only on the nucleation surface ($S_{NDL}$) 6A. That is, the nucleation surface ($S_{NDL}$) 6A is required to be formed sufficiently minutely so that only a single nucleus may be formed thereon. The size of the nucleation surface ($S_{NDL}$) 6A, which may differ depending on the kind of the material, may be several microns or less. Further, the nucleus grows while maintaining a single crystal structure to become a single crystal grain 7 in shape of an island as shown in Fig. 4(B). For forming an island-shaped single crystal grain 7, it is desirable to determine the conditions so that nonnucleation may occur at all on the thin film 5A, as already mentioned.

The island-shaped single crystal grain 7 further grows while maintaining the single crystal structure with the nucleation surface ($S_{NDL}$) 6A as the center (lateral overgrowth), whereby it can cover over the whole surface of the thin film 5 as shown in Fig. 4(C) (single crystal 7A).

Subsequently, if necessary, the single crystal 7A is flattened by etching or polishing, and a single crystal layer 8 capable of forming a desired device can be formed on the thin film 5 as shown in Fig. 4(D) and Fig. 5(B).

Thus, due to formation of the thin film 6 forming the nucleation surface ($S_{NDL}$) 6A on the substrate 4, any desired material can be used for the substrate 4 which is the supporting member. Further, in such a case, even when the substrate 4 may be one having a functional device, etc., formed thereon according to conventional semiconductor technique, the single crystal layer 8 can be easily formed thereon.

In the above embodiment, the nucleation surface ($S_{NDL}$) 6A is formed of thin film 6, but a substrate comprising a material with large nucleation density (ND) enabling selective nucleation may be used as such and nonnucleation surfaces ($S_{NDS}$) may be provided at any desired positions to form single crystal layers similarly thereon as shown in Fig. 6.

Figs. 6(A)-6(D) are illustrations of the steps for forming crystal showing a second embodiment of the present invention. As shown in these figures, on a substarte 9 comprising a material with large nucleation density (ND) enabling selective nucleation, the nonnucleation surface ($S_{NDS}$) comprising a material with small nucleation density (ND) can be formed so as to give exposed portions of the substrate 9 as nucleation surface ($S_{NDL}$) 9A sufficiently minutely to form a single crystal layer 8 similarly as in the first embodiment.

Figs. 7(A)-7(D) are illustrations of the formation steps showing a third embodiment of the method for forming crystal according to the present invention, and Figs. 8(A) and 8(B) are perspective views corresponding to Figs. 7(A) and 7(D).

As shown in Fig. 7(A) and Fig. 8(A), on an appropriate base substrate 10 such as glass substrate, etc., an amorphous insulating thin film 12 with relatively greater nucleation density (ND) such as $Si_3N_4$, etc., 20 is provided, and on said thin film 12 is formed selectively a thin film 11 at a desired position with a different material having smaller nucleation density relative to the material forming the thin film 12 which enables the above selective nucleation with an interval of a distance ℓ, thereby arranging nucleation surfaces ($S_{NDL}$) 12A-1, 12A-2 with sufficiently small areas so as to form only single nucleus thereon. This distance ℓ may be set at a size which is equal to or greater than the size of the single crystal region required for formation of a semiconductor device or a group of devices.

Next, by selecting appropriate crystal forming conditions, on the nucleation surface ($S_{NDL}$) 12-1, 12-2 only a nucleus of a crystal forming material is formed. That is, as described above, the nucleation surfaces 12-1, 12-2 are required to be formed to a sufficiently fine size (area) to the extent that only a single nucleus may be formed. The size of the nucleation surfaces ($S_{NDL}$) 12-1, 12-2, which may be different depending on the kinds of the material, may be several microns or less. Further, the nucleus formed as above grows while maintaining the single crystal structure, and become island-shaped single crystal grains 13-1, 13-2 as shown in Fig. 7(B). For forming island-shaped single crystal grains 13-1, 13-2, it is desirable to determine the conditions so that substantially no nucleation may occur at all on other surfaces than the nucleation surfaces ($S_{NDL}$) 12A-1, 12A-2, [nonnucleation surface ($S_{NDS}$) 11A].

The crystal direction in the normal line direction of the thin film 12 of the island-shaped single crystal grains 13-1, 13-2 is determined so as to make the interface energy of the material of the film 12 and the material forming nucleus minimum. For, surface or interface energy has anisotropy depending on the crystal face. However, as already mentioned, the crystal direction within the surface plane in amorphous surface is not determined.

The island-shaped single crystal grains 13-1, 13-2 further grow to become single crystals 13A-1, 13A-2 until the adjacent single crystals 13A-1, 13A-2 contact each other as shown in Fig. 7(C), but since the crystal directions within the substrate plane vary from one single crystal to another, a crystal grain boundary 14 is formed at the intermediate position between the nucleation surfaces ($S_{NDL}$) l2-1 and 12-2.

Subsequently, the single crystals 13A-1, 13A-2 grow three-dimensionally, but crystal faces with slow growth speed appear as the facet. For this reason, the surfaces of single crystals 13A-1, 13A-2 are flattened by etching or polishing, and further the portion of the grain boundary 14 is removed to form thin films of single crystals 15-1, 15-2, ... containing no grain boundary in shape of lattices as shown in Fig. 7(D) and Fig. 8(B). The size of the single crystal films 15-1, 15-2, ... is determined by the interval ℓ between the nucleation surfaces ($S_{NDL}$) 12A-1, 12A-2 as described above. That is, by determining appropriately the formation pattern of the nucleation surface ($S_{NDL}$) 12A-1, 12A-2, the position of the grain boundary can be controlled to form single crystals with desired sizes at a desired arrangement.

Figs. 9(A)-9(C) are illustrations of the formation steps showing a fourth embodiment of the method for forming crystal according to the present invention, and Figs. 10(A)-10(B) are perspective views of the substrates in Figs. 9(A) and 9(C).

First, as shown in Fig. 9(A) and Fig. 10(A), similarly as shown in the step (A) in Fig. 1, thin films 12 and 11 are provided on the base substrate 10 to form nucleation surfaces ($S_{NDL}$) 12A-1, 12A-2 and nonnucleation surface ($S_{NDS}$) 11A. Subsequently, so that concavities 14-1, 14-2 with desired sizes and shapes may be provided at the corresponding positions to the nucleation surfaces ($S_{NDL}$) 12A-1, 12A-2, a thin film 11-1 is formed with the same material as the thin film 11A or a material having nucleation density equal to or smaller than said material. Thus, a substrate for formation of crystal having nucleation surfaces ($S_{NDL}$) 12A-1, 12A-2 with sufficiently fine sizes for forming only single nucleus within concavities 14-1, 14-2 is formed.

Subsequently, as shown in Fig. 9(B), island-shaped single crystal grains 13 are grown similarly as in the first embodiment.

And, as shown in Fig. 9(C) and Fig.10(B), single crystal grains 13-1, 13-2 are grown until embedding the concavity 14-1, 14-2 to form a single crystal layer 15-1, 15-2.

In this embodiment, since single crystal grains 13-1, 13-2 grow within the concavity 14-1, 14-2, the steps of flattening and removing the grain portion may be unnecessary.

Fig. 11 is a schematic sectional view showing an example of the semiconductor electronic device with a multi-layer structure produced by use of the first embodiment of the present invention.

In Fig. 11 on the semiconductor substrate 1101 such as Si or GaAs, transistors 1102 or other semiconductor devices or optical devices are formed, and $Si_3N_4$ layer 1104 having, a surface for formation of, for example, nucleation surface ($S_{NDL}$) 1105 is formed thereon according to the CVD method or the sputtering method. And, as already mentioned, nucleation surfaces ($S_{NDL}$) 1105 are exposed as sufficiently minute areas so that only a single nucleus may be formed and a thin film 1106 of, for example, $Si_3N_4$ having nucleation surface ($S_{NDS}$) 1107 is formed and from said nucleation surface ($S_{NDL}$) 1105 single crystal layer 1108 is formed. In the Figure, 1103 denotes $SiO_2$ layer.

Subsequently, on the single crystal layer 1108 are formed transistors 1109 or other semiconductor devices or optical devices, and the devices formed respectively on the substrate 1101 and the Si single crystal layer 1107 are electrically connected through the $Si_3N_4$ layer 1104. Thus, for example, by forming the transistor 1102 of the first layer (substrate 1101) and the transistor 1109 of the second layer (single crystal layer 1108) respectively as the MOS transistors, and connecting these to form CMOS, a CMOS entirely free from mutual interaction can be produced. Also, according to the technique as described above, an electroluminescent device can be also formed integrated with its driving circuit to accomplish a high degree of integration.

Further, by repeating this embodiment, single crystal layers 1108 can be formed in many layers with $Si_3N_4$ layer

1104 sandwiched therebetween, whereby a semiconductor electronic device with a multiple structure can be formed easily.

Figs. 12(A)-12(D) are illustrations of the steps for forming crystal showing an fifth embodiment of the present invention. Figs. 12(A)-12(C) are the same as Figs. 7(A)-7(C). That is, a plurality (two in the Figure) of nucleation surfaces 12A-1, 12A-2 are formed with an interval of $\ell$, and single crystal grains 13-1, 13-2 subjected to over growth on the nucleation surfaces 12A-1, 12A-2 are formed. By permitting the single crystal grains 13-1, 13-2 to further grow to form single crystals 13A-1, 13A-2 a grain boundary 14 is formed approximately at the center of the nonnucleation surfaces ($S_{NDS}$) 11A, and by flattening the surface of single crystal 13A-1, 13A-2 a polycrystalline layer 16 with regular grain sizes which are approximately equal to $\ell$ as shown in Fig. 12(D) can be obtained.

Since the grain size of the polycrystalline layer 16 is determined by the interval $\ell$ between the nucleation surfaces ($S_{NDL}$) 12A-1, 12A-2 , it becomes possible to control the grain size of the polycrystal. In the prior art, the grain size of a polycrystal was changed by a plural number of factors such as the formation method, formation temperature, etc., and also when preparing a polycrystal with large grain size, it had a grain size distribution with a considerable width. However, according to the present invention, the grain size and grain size distribution can be determined with good controllability by the interval $\ell$ between the nucleation surfaces ($S_{NDL}$) 12A-1, 12A-2.

Of course, as shown in Fig. 6, polycrystal layer may be formed as above by forming a thin film having nonnucleation surface ($S_{NDS}$) 5A with small nucleation density (ND) on a desired substrate 9 and plural nucleation surafces ($S_{NDL}$) 9A with greater nucleation density (ND) at desired positions and intervals. In this case, as already mentioned, the substrate material and structure are not limited provided that the nucleation density difference ($\Delta$ND) is taken into consideration but the polycrystal layer can be formed by controlling the grain size and the grain size distribution.

Next, the specific method for forming a single crystal layer or a polycrystal layer in the above respective embodiments is described in more detail by referring primarily to the third embodiment shown in Fig. 7.

By thermal oxidation of a Si single crystal wafer to form a $SiO_2$ layer on the surface and subsequent thin film formation of $Si_3N_4$ or polycrystalline Si layer to a desired thickness by the reduced pressure chemical vapor deposition method, a surface with a large nucleation density (ND) is obtained. Of course, a quartz substrate which is a material with small nucleation density (ND) can be also used as a base substrate 10, or alternatively a surface with a large nucleation density (ND) may be provided by forming a thin film 12 of $Si_3N_4$ or polycrystalline Si layer on the surface of any desired base substrate such as metal, semiconductor, magnetic material, piezoelectric material, insulator, etc., by use of the sputtering method, the CVD method, the vacuum vapor deposition method, etc. Also, as the material for formation of the thin film 12 partially providing nucleation surfaces ($S_{NDL}$), $Si_3N_4$ is desirable, but $SiN_X$ ($0 < x < 4/3$) with the value of x being varied may be also employed.

On the above thin film 12 thus formed on the substrate 10 is deposited a thin film 11 of $SiO_2$ or $Sio_y$ ($0 < Y < 2$) according to the reduced pressure chemical vapor deposition method, and subsequently the above thin film 11 is subjected to patterning according to conventional lithographic technique or lithographic technique by use of X-ray, electron beam or ion beam to selectively exposed the surface of the thin film 12, whereby nucleation surfaces ($S_{NDL}$) 12A-1, 12A-2 having fine area of preferably 10 µm or less, more preferably several microns or less, optimally about 1 µm or less, are obtained.

Subsequently, by use of $SiH_2Cl_2$, $SiCl_4$, $SiHCl_3$ $SiF_4$ or $SiH_4$ or a gas mixture of these, optionally mixed with HCl, $H_2$ or a gas mixture of these, Si single crystal is selectively grown on the above nucleation surface ($S_{NDL}$) 12A-1, 12A-2.

The substrate temperature, pressure, etc., may be conveniently determined, but the substrate temperature may be preferably 700 to 1100 °C, and the pressure may be preferebly about 100 Torr.

Within a time of about some 10 minutes, by selection of optimum growth conditions, grains 13-1, 13-2 of single crystals of Si grow on the nucleation surfaces ($S_{NDS}$) 12A-1, 12A-2 as the center, and grow to sizes of some 10 µm or more.

Subsequently, by the reactive ion etching (RIE) method utilizing the etching speed difference between Si and $SiO_2$, the surfaces of the single crystals 13A-1, 13A-2 are flattened by selective etching of only Si, whereby a polycrystalline silicon layer controlled in grain size can be formed. Further, by removing the grain boundary portion, island-shaped single crystalline silicon layers 15-1, 15-2 are formed (Fig. 7(D)). If unevenness on the surface of the single crystal grains 13A-1, 13A-2 are large, mechanical polishing may be conducted before etching. When electrical field effect transistors are formed according to conventional semi-conductor device preparation technique on the single crystal silicon layers 15-1, 15-2 thus formed with a size of some 10 µm or more containing no grain boundary, characteristics not inferior to that formed on single silicon wafer are exhibited.

Also, mutual interference between the adjacent single crystal silicon layers can be prevented, if they are electrically separated by an electrical insulator such as $SiO_2$, even if a complementary type electrical field effect transistor (C-COM) may be constituted.

Also, since the thickness of the active layer of the device formed is thinner than the case when employing Si wafer, there is no erroneous actuation by the charges generated when radiation is irradiated. Further, due to lowering in unwanted capacity, speed-up of the device can be effected. Also, since any desired substrate can be used, a single crystal layer can be formed on a substrate of large area at lower cost than when employing Si wafer. Further, since a single crystal layer can be formed also on other semiconductors, piezoelectric materials, dielectric materials, etc., a multi-functional three-dimensional integrated circuit can be realized. Thus, the present invention exhibits a number of excellent effects.

(Composition of silicon nitride)

For obtaining sufficient nucleation density difference (ΔND) between the material ($M_S$) for formation of nonnucleation surface ($S_{NDS}$) and the material ($M_L$) for formation of nucleation surface ($S_{NDL}$) as described above, for polycrystalline silicon or $SiO_2$ as the material for formation of nonnucleation surface ($S_{NDS}$) to be used in combination, the material for formation of nucleation surface ($S_{NDL}$) is not limited to $Si_3N_4$, but silicon nitrides with various chemical composition ratios may be employed.

The chemical composition ratio of silicon nitride may be varied e.g. as follows.

In the plasma CVD method for forming silicon nitride film at low temperature by decomposition of $SiH_4$ gas and $NH_3$ gas in RF plasma, by varying the flow rate ratio of $SiH_4$ gas and $NH_3$ gas, the composition ratio of Si and N in the deposited silicon nitride film can be varied to a great extent.

Fig. 13 is a graph showing an example of the relationship between the flow rate ratio of $SiH_4$ and $NH_3$ and the composition ratio of Si and N in the silicon nitride film formed.

The deposition conditions at this time were RF output of 175 W, substrate temperature of 380 °C and the flow rate of $NH_3$ gas was varied with the $SiH_4$ gas flow rate being fixed at 300 cc/min. As shown in the same graph, by varying the gas flow rate ratio of $NH_3/SiH_4$ from 4 to 10, the Si/N ratio in the silicon nitride film was found to be varied from 1.1 to 0.58 according to Auger's electron spectrophotometry.

On the other hand, the composition of the silicon nitride film formed according to the reduced pressure CVD method by introducing $SiH_2Cl_2$ gas and $NH_3$ gas under the conditions of a reduced pressure of 0.3 Torr and a temperature of about 800 °C was found to be $Si_3N_4$ (Si/N = 0.75) which is approximately the stoichiometric ratio.

Also, the silicon nitride film formed by heat treatment at about 1200 °C in ammonia or $N_2$ (hot nitrification method) can be obtained with a composition further approximate to the stoichiometric ratio, since the formation method is performed under thermal equilibrium.

By use of silicon nitrides formed by the various methods as described above as the material for forming nucleation surface ($S_{NDL}$) with higher nucleation density than $SiO_2$, the above nucleus of Si can be grown on the nucleation surface ($S_{NDL}$) comprising silicon nitride to form Si single crystal based on the nucleation density (ΔND) corresponding to the chemical composition ratio of silicon nitride.

Fig. 14 is a graph showing the relationship between Si/N composition ratio and nucleation density (ΔND). As shown in the same graph, by varying the chemical composition ratio of the silicon nitride film, the nucleation density of the Si single crystal nucleus formed thereon changes to a great extent. The nucleation conditions in the graph shown in Fig. 14 correspond to the case when Si single crystal nucleus was formed by reacting $SiCl_4$ gas reduced to 175 Torr with $H_2$ at 1000 °C. Of course, another graph will be obtained if nucleation conditions such as gas species, pressure, temperature, etc., are changed.

The phenomenon that the nucleation density thus changes according to the chemical composition ratio of silicon nitride affects the size (area) of the nucleation surface ($S_{NDL}$) when employing silicon nitride as the material for forming the nucleation surface ($S_{NDL}$) which is formed sufficiently finely to the extent that a single nucleus may be grown. That is, when employing silicon nitride having a composition with great nucleation density (ND) only a single crystal can be formed on the nucleation surface ($S_{NDL}$) by forming the nucleation surface ($S_{NDL}$) extremely finely as compared with the silicon nitride with relatively smaller nucleation density (ND). Such a point is applicable as a similar tendency for other materials for forming nucleation surface ($S_{NDL}$). Accordingly, in the present invention, for accomplishing its objects effectively, it is desirable to select a nucleation density (ND) and a size of nucleation surface ($S_{NDL}$) formed of silicon nitride, etc., capable of forming only a single crystal suitably as desired. For example, under the nucleation condition for obtaining a nucleation density (ND) of about $10^5$ $cm^{-2}$, it is possible to form selectively only a single nucleus, if the size of the nucleation surface ($S_{NDL}$) comprising silicon nitride is about 4 μm or less. The Si/N ratio in that case is about 0.5.

(formation of nucleation surface ($S_{NDL}$) by ion injection)

As another method for realizing nucleation density difference (ΔND) when forming Si single crystal nucleus, ion injection of N, P, B, F, Ar, He, C, As, Ga, Ge, etc., may be effected locally onto the single crystal Si surface of the above substrate provided at desired positions and intervals with $SiO_2$ thin layer which is a material for forming nonnucleation surface ($S_{NDS}$) with smaller nucleation density thus resulting in partial exposure of the single crystal surface to form a modified region, and utilize this modified region as the nucleation surface ($S_{NDL}$) with greater nucleation density (ND).

For example, the $SiO_2$ layer surface given on the single crystal Si substrate is covered with a photo-resist layer and the desired portions are exposed, developed and dissolved to have the surface of the single crystal Si substrate exposed.

Subsequently, while the remaining photoresist layer is left as it is, by use of $NH_3$ gas as the source gas, N ions are implanted onto the single crystal Si layer surface portion exposed at 15 keV at a density of $1 \times 10^{16}$ - $1 \times 10^{18}$ $cm^{-2}$. The projected flying distance in this case is 120 Å, and the N concentration on the exposed surface of single crystal Si layer reaches about $10^{22}$ $cm^{-3}$. The modified region made excessively enriched in N by injection of N ions is amorphous.

For formation of a modified region, ion injection can be effected with the use of a resist as the mask, but it is also possible to inject a narrowed N ion beam selectively at an exposed single crystal Si portion of the layer surface without use of a resist mark by use of converged ion beam technique.

After having thus effected N ion injection, by peeling of the resist on the remaining portion, N-excessive modified region is formed in the single crystal Si layer surface at a desired position with a desired size. On the modified region of the substrate for crystal growth having such modified region formed, Si single crystal is permitted to grow in vapor phase.

(Method for formation of Si single crystal nucleus other than CVD)

For growth of single crystal by selective nucleation of Si, not only the CVD method, but also the method by evaporation of Si into vacuum (< $10^{-6}$ Torr) with an electron gun and deposition on a heated substrate may be used. Particularly, in the MBE (Molecular Beam Epitaxy) method which performs vapor deposition in ultra-high vacuum (< $10^{-9}$ Torr), it has been known that Si begins to react with $SiO_2$ at a substrate temperature of 900 °C or higher, whereby no nucleation of Si occurs on $SiO_2$ at all (T. Yonehara, S. Yoshioka and S. Miyazawa, Journal of Applied Physics 53, 10, p. 6839, 1983).

By utilizing this phenomenon, single crystal nuclei of Si can be formed with perfect selectivity on the fine silicon nitride regions permitted to exist in spots on the $SiO_2$ thin film by giving concavities and exposing it, and single crystal Si can be grown from the nuclei. The single crystal growth conditions as preferable example at this time may be, for example, a vacuum degree of $10^{-8}$ Torr or lower, Si beam intensity of $9.7 \times 10^{14}$ atoms/$cm^2$·sec, and a substrate temperature of 900 °C - 1000 °C.

In this case, through the reaction $SiO_2 + Si \rightarrow 2SiO\uparrow$, a reaction product of SiO with a remarkably high vapor pressure is formed, and etching of $SiO_2$ itself with Si through this evaporation occurs.

In contrast, no such etching phenomenon as mentioned above occurs on silicon nitride thin film, but nucleation of Si single crystal and growth of single crystal occur.

Accordingly, as the material for forming nucleation surface ($S_{NDL}$) with high nucleation density (ND), tantalum oxide ($Ta_2O_5$), silicon nitride oxide (SiON), etc., can be also used other than silicon nitride to obtain the same effect. That is, by forming the above nucleation surface ($S_{NDL}$) with these materials in fine areas, single crystals of Si can be permitted to grow similarly.

(Crystal growth of material other than Si)

(1) As the crystalline material other than Si, the case of diamond is shown as an Example, as already mentioned, it has been desired to apply a diamond thin film as the semiconductor for electronic device, it has been impossible in the prior art to grow a diamond single crystal on a material other than the diamond substrate.

However, according to the crystal growth method according to the present invention, a diamond single crystal can be easily grown on a material other than diamond substrate. Here, explanation is made about an example of forming a single crystal of diamond by utilizing the fact that no single crystal nucleus of diamond grows on the surface of a metal such as Fe or Co.

First, on a desired base substrate, a thin film of a metal such as Cu, W, Ta, Mo, Au, Ti, Al, Ni, etc., is deposited according to the vacuum vapor deposition method, or a semiconductor material thin film such as of Si, Ge, GaAs, InP, SiC, etc., according to the CVD method or the vacuum vapor deposition method. These thin films ($F_L$) form nucleation surfaces ($S_{NDL}$) having a large nucleation density (ND) mentioned in this specification. Subsequently, on the film ($F_L$), a metal thin film of Fe or Co is formed by the vacuum vapor deposition method. This metal thin film has a polycrystalline structure. These metal films ($F_S$) have a sufficient smaller nucleation density as compared with the above thin film ($F_L$). Subsequently, the above thin film ($F_S$) is subjected to patterning so as to expose the above film ($F_L$) to a size of several micrometer to form a nucleation surface ($S_{NDL}$) with a sufficiently minute area.

Thus, single crystal diamond is crystallized on the nucleation surface under the following conditions.

As the method for crystallization of diamond, there may be employed the CVD method according to the microwave plasma CVD method, the hot filament method, etc. As the starting gases, for example, there may be employed gas

mixtures of methane ($CH_4$) and hydrogen (1 - 10 %), or hydrocarbons having alcoholic OH groups, specifically methyl alcohol $CH_3OH$, ethyl alcohol $C_2H_5OH$, tert-butyl alcohol $(CH_3)_3OH$, isopropyl alcohol $(CH_3)_2)CHOH$, diethyl ether $C_2H_5OC_2H_5$, etc., by bubbling these liquids with hydrogen gas.

In the case of the plasma CVD method, it can be practiced, for example, under the conditions of a microwave output of 200 to 350 W, a substrate temperature of 500 to 1000 °C and a reduced pressure of 1 to 400 Torr.

In the case of the CVD method by use of the hot filament method, it can be practiced, for example, under the conditions of a filament temperature of about 1500 to 2000 °C and a filament-substrate distance of 0.5 to 10 mm.

As the result, no nucleation of diamond occurs at all on the metal thin film ($F_S$) of Fe or Co, but only a single diamond single crystal nucleus is formed on the nucleation surface ($S_{NDL}$) with higher nucleation density (ND) minutely formed by exposing the thin film ($F_L$) out of the thim film ($F_S$), and thereafter diamond grains of single crystals grow to the sizes of some 10 µm to some 100 µm with the single diamond nuclei as their centers. In these diamond grains, there may sometimes exist internally the twin crystal grain boundaries without unpaired electrons depending on the crystal forming conditions, but there exists no grain boundary containing much unpaired electrons as found in the so called polycrystalline structure. This is because growth of a diamond single crystal from a single nucleus formed on the nucleation surface ($S_{NDL}$) is not inhibited due to absence of formation of diamond nucleus on the nonnucleation surface ($S_{NDS}$) formed of a material such as Fe or Co with lower nucleation density.

Fig. 15 is a graph showing the time dependency of nucleation density of the diamond on the surface of Fe, Co, Si, Mo.

As shown in this graph, it is possible to take sufficiently a difference in nucleation density of diamond on the surface of a metal of Fe, Co and on the surface of Si, Mo. This point is the same as in the case of nucleation density of Si on the surface of $Si_3N_4$ and on the surface of $SiO_2$ shown in Fig. 3.

Thus, by forming a layer for formation nucleation surface ($S_{NDL}$) with higher nucleation density (ND) on the base substrate of any desired material other than diamond substrate, and thereon forming a thin film giving nonnucleation surface ($S_{NDS}$) with lower nucleation density (ND) so as to expose the surface of the above thin film ($F_L$) selectively at a sufficiently minute area, diamond single crystal can be formed with ease using the thus obtained substrate for crystal formation. Of course, as already mentioned, it is possible to form a diamond thin film of a polycrystalline structure with controlled grain size by arranging nucleation surfaces ($S_{NDL}$) having fine areas at desired intervals.

Also, according to the present invention, as the base substrate, it may in principle be a substrate of the material capable of forming a thin film ($F_L$) giving the above nucleation surface ($S_{NDL}$), and therefore the selection scope can be broadened to a great extent to accomplish low cost and enlargement of area with ease.

(2) Growth of tungsten signle crystal

Tungsten has been known to effect no nucleation on the surface of $SiO_2$ layer, but to be deposited as a polycrystalline film on Si, $WSi_2$, PtSi, Al, etc.

First, on a suitable substrate, a thin film ($F_L$) of Si, $WSi_2$, PtSi or Al is deposited by vacuum vapor deposition. These films provide surfaces forming nucleation surface ($S_{NDL}$). Next, on the thin film ($F_L$) comprising the above material, a thin film ($F_S$) comprising a material with small nucleation density (ND) such as $SiO_2$, etc., is formed according to the heat oxidation treatment, hot CVD, PCVD, sputtering, etc. Then, the substrate subjected to patterning so as to expose the above thin film ($F_s$) to a size of several µm or less by photolithography to form a desired number of nucleation surface ($S_{NDL}$).

Subsequently, the substrate for crystal formation prepared as above is placed in, for example, a reaction furnace heated to 250 - 500 °C, and a gas mixture of $WF_6$ gas and hydrogen gas is permitted to flow under a reduced pressure of about 0.1 to 10 Torr, at the respective flow rate of 75 cc/min and 10 cc/min.

By doing so, tungsten is formed as represented by the reaction scheme $WF_6 + 3H_2 \rightarrow W + 6HF$. In this case, the reactivity of tungsten with $SiO_2$ is extremely low to give no firm bonding, and therefore no nucleation occurs on the surface of the thin film ($F_S$) of e.g. $SiO_2$ and hence no deposition is effected.

In contract, on the above nucleation surface ($S_{NDL}$) formed of a thin film ($F_L$) of Si, $WSi_2$, PtSi, Al, etc., single crystal nuclei of tungsten are formed single crystal nuclei of tungsten singly, because nucleation surfaces ($S_{NDL}$) are formed minutely. And, the single crystal of tungsten continues to grow and also grows as such single crystal also in the lateral direction on the thin film ($F_S$). This is because nonnucleus growth of tungsten occurs on the thin film ($F_S$), whereby no polycrystal is formed by interference of single crystal growth.

The combination of the nonnucleation surface ($S_{NDS}$) forming material, nucleation surface ($S_{NDL}$) forming material and crystal forming material as described above is not limited to those shown in the above embodiments, but it may be clearly a combination of materials having sufficient nucleation density difference ($\Delta$ND). Accordingly, also in the case of a compound semiconductor capable of selective nucleation such GaAs, InP, etc., a single crystal, a group of single crystals or a polycrystal controlled in grain size and grain size distribution can be formed according to the present invention.

Example 1

A 5 inch Si single crystal wafer was set in a reduced pressure chemical vapor deposition device and $Si_3N_4$ layer was formed to a thickness of 300 Å (formation of nonnucleation surface ($S_{NDS}$)) according to the hot CVD method under the deposition conditions as follows.

| | |
|---|---|
| Pressure | 0.3 Torr |
| Gases used | $SiH_2Cl_2$ + $NH_3$ gas mixture |
| Flow rate ratio | $NH_3/SiH_2Cl_2$ = 7 |
| Temperature | 820 °C |

Next, the above Si single crystal wafer having $Si_3N_4$ layer formed thereon was set in a reduced pressure chemical vapor deposition device, and a $SiO_2$ layer was formed to a thickness of 500 Å on the $Si_3N_4$ layer according to the hot CVD method under the following deposition conditions.

| | |
|---|---|
| Pressure | 1.0 Torr |
| Gases used | $SiH_4$ + $N_2O$ |
| Flow rate ratio | $SiH_4/N_2O$ = 5 |
| Substrate temperature | 700 °C |

Next, the above $SiO_2$ layer was subjected to patterning according to X-ray lithographic technique to form $Si_3N_3$ minute regions for nucleation surfaces ($S_{NDL}$) of $Si_3N_4$ exposed thereat in a matrix arrangement of 50 × 100 with sizes of 1 µm and 150 µm pitch.

On the Si single crystal wafer having thus provided nonnucleation surface comprising $SiO_2$ ($S_{NDS}$) and nucleation surfaces ($S_{NDL}$) of 50 × 100 of $Si_3N_4$ exposed thereat, Si single crystals were grown according to the hot CVD method under the Si single crystal growth conditions shown below.

| | |
|---|---|
| Pressure | 150 Torr |
| Gases used | $SiH_2Cl_2$ |
| Flow rate | 1.2 liter/min |
| Temperature | 1030 °C |
| Crystal growth time | 40 min |

The Si single crystal wafer applied with the crystal preparation treatment was taken out from the device, and the crystal was evaluated by observation with an electron microscope and X-ray diffraction. As the result, it was found that 50 × 100 Si single crystals with grain size of 80 µm and substantially no grain size distribution were formed with the above region of exposed $Si_3N_4$ as the center.

All of these Si single crystals were shown to have single crystal properties of extremely good quality.

Example 2

Under the same conditions as in Example 1 except for taking sufficiently the time for growth of Si single crystals, an Si polycrystalline layer comprising the state in which adjacent Si single crystals mutually contact each other as shown in Fig. 12(D) was formed. On the surface of the polycrystalline layer, smoothening treatment was applied according to the selective etching method as conventionally practiced in the field of semiconductors.

By use of the Si polycrystalline layer having thus smoothened surface, P-MOS transistor was prepared according to the method conventionally used in the field of semiconductors and actuation characteristics were measured. As the result, it was found to be by far superior to the case of P-MOS transistor formed by use of the Si polycrystalline layer obtained according to the prior art method.

Example 3

When Si single crystal group as shown in Fig. 7(D) was prepared under the growth conditions of substrate for formation of crystal and the crystal growth conditions shown below and otherwise similar to Example 1, and evaluated in the same manner as in Example 1, the same results as in Example 1 were obtained.

[Substrate growth conditions]

| | |
|---|---|
| Substrate | Si polycrystallien substrate having $Si_3N_4$ layer to a thickness of 300 Å provided according to the hot CVD method |
| Pressure | 0.4 Torr |
| Gases used | $SiH_2Cl_2 + NH_3$ gas mixture |
| Flow rate ratio | $NH_3/SiH_2Cl_2 = 7$ |
| Temperature | 850°C |

Minute region of exposed silicon nitride [nucleation surface ($S_{NDL}$)]

0.5 µm size, 200 µm pitch, 100 x 100 matrix arrangement

[Crystal growth conditions]

| | |
|---|---|
| Pressure | 140 Torr |
| Gases used | $SiHCl_3$ |
| Flow rate | 1.5 liter/min |
| Temperature | 1100°C |
| Crystal growth time | 60 min |

[Si single crystal which is grown]

Grain size 170 µm
Substantially no grain size distribution

Example 4

A single crystal of diamond was prepared as described below.

A quartz base substrate was prepared, and an Si thin film with a thickness of 250 Å was provided on its surface according to the sputtering method. Next, on the Si thin film, a Co thin film was formed to a thickness of 500 Å according to the vacuum vapor deposition method by resistor heating.

Subsequently the Co thin film was subjected to patterning treatment according to the photolithographic method to form a nucleation surface ($S_{NDL}$) form of thin film minute region in shape of 100 × 100 matrix with 1 µm size and 100 µm pitch (formation of diamond single crystal substrate).

By use of the thus obtained substrate for growth of single crystals, single crystals of diamond were grown according to the microwave plasma CVD method under the following conditions.

| | |
|---|---|
| Microwave output | 300 W |
| Substrate temperature | 950°C |
| Pressure | 30 Torr |
| Starting material used | $CH_3OH$ ($H_2$ bubbling) |
| Flow rate | 0.5 liter/min |

Single crystal of diamond thus obtained had grain size of 60 µm substantially without grain size distribution, having extremely good electrical insulation and excellent thermal conductivity.

Example 5

Single crystals of tungsten were grown as described below.

A Si single crystal wafer was prepared, and an Al thin film with a thickness of 800 Å was provided on its surface according to the vacuum vapor deposition method. Next, on the Al thin film, by use of ($SiH_4 + O_2$) gas mixture diluted with He, a $SiO_2$ thin film was formed to a thickness of 500 Å according to the plasma CVD method at a substrate temperature of 300 °C.

This $SiO_2$ thin film was then subjected to patterning by photolithography into a matrix of 50 × 50 with 5 µm size and 100 µm pitch [preparation of nucleation surface ($S_{NDL}$)].

On the thus obtained substrate for preparation of tungsten single crystals, single crystals of tungsten were prepared according to the hot CVD method under the following conditions. As a result, the grain size was 70 µm substantially without grain size distribution. All of the tungsten crystals formed on the substrate exhibited excellent single crystal properties.

| | |
|---|---|
| Substrate temperature | 300 °C |
| Pressure | 1 Torr |
| Gases used | $WF_6$ + $H_2$ gas mixture |
| $WF_6$ flow rate | 75 cc/min |
| $H_2$ flow rate | 10 cc/min |
| Crystal preparation time | 100 min |

As described in detail above, the crystal and the method for formation thereof according to the present invention, by forming sufficiently finely the nucleation surface ($S_{NDL}$) of a material with sufficiently greater nucleation density (ND) than the material for formation of nonnucleation surface ($S_{NDS}$) so that only a single nucleus may grow, permit single crystals to grow selectively at the sites where the fine nucleation surfaces ($S_{ND}$) exist, whereby crystals such as a single crystal with a necessary size, a plurality of island-shaped single crystals, a polycrystal controlled in grain size and grain size distribution, etc., can be formed easily on a base substrate of any desired material. Besides, no special new preparation device is required, but it can be formed by use of a device conventionally used in semiconductor process.

Also, the crystal according to the present invention is not limited to the materials of base substrates as in the prior art, and therefore three-dimensional integration, enlargement of area and reduction in cost can be easily accomplished. For example, since a single crystal or polycrystal of silicon which is the main material of semiconductor device can be easily formed on an amorphous insulating material, multi-layer of devices with excellent electrical properties can be accomplished to realize a multi-functional integrated circuit not found in the prior art. More specifically, it becomes possible to integrate or combine an optical device, a surface acoustic device, a piezoelectric device, etc., with the surrounding circuit IC of the respective devices, etc. Also, by use of a cheap glass or ceramic, etc., as the base material, application for a large area electronic device such as a large scale flat panel display in which driving circuits are integrated in a sheet of glass, etc., is rendered possible.

Further, the present invention, by forming the above nucleation surfaces ($S_{NDL}$) with desired sizes and desired distances on the nonnucleation surface ($S_{NDS}$), can form single crystals with necessary sizes on a plural number of sites, and therefore the formation steps can be simplified to a great extent and also the formation time can be shortened as compared with the melting solidification method in which single crystals are formed by irradiation of laser or electron beam.

Also, by controlling the intervals of the nucleation surfaces ($S_{NDL}$) formed on the above nonnucleation surface ($S_{NDS}$), a polycrystal controlled in grain size by the intervals can be formed. In this polycrystal formation method, controllability of grain size and grain size distribution is good and the formation time can be also shortened to a great extent as compared with the method of the prior art for forming a polycrystal with a large grain size according to the above melting solidification method.

## Claims

**1.** A method (fig 4; fig 6; fig 7; fig 9; fig 12) for producing on the surface of a substrate (4; 9; 10) one or more single crystals (7A; 7; 13A-1 and 13A-2) of a crystal forming material, which method comprises:

establishing at a free surface of said substrate one or more deposition surface areas (6A; 9A; 12A-1 and 12A-2) having under chosen conditions of deposition a higher deposition rate than that of the adjacent deposition surface area or areas (5A; 11A and 11-1A), so that said crystal forming material deposits selectively on said one or more deposition surface areas (6A; 9A; 12A-1, 12A-2),

wherein the step of establishing said one or more deposition surface areas (6A; 9A; 12A-1 and 12A-2) and adjacent deposition surface area or areas (5A; 11A and 11-1A) comprises depositing a thin film (5; 11) of material which is to form said adjacent deposition surface area or areas (5A; 11A and 11-1A) onto the surface of said substrate (4; 9; 10) and opening one or more windows in said thin film by photolithographic patterning (including x-ray lithography) or by patterning with an electron beam or ion beam whereby said one or more deposition surface areas (6A; 9A; 12A-1 and 12A-2) are exposed to said crystal forming material via said corresponding one or more windows in said adjacent deposition surface area or areas (5A; 11A and 11-1A); and

depositing said crystal forming material on the exposed free surface (5A and 6A; 5A and 9A; 11A; 12A-1 and 12A-2) of said substrate (4; 9; 10) under said chosen conditions of deposition;

characterised in that:

(a) said one or more deposition surface areas (6A; 9A; 12A-1 and 12A-2) have surface properties which exclude an epitaxial growth of a single crystal of said crystal forming material on said one or more deposition surface areas;

(b) the difference in deposition rates arises because the surface properties of the deposition surface area or areas and of the adjacent surface area or areas are such that a higher number of nuclei form per unit area in the deposition surface area or areas than in the adjacent surface area or areas; and

(c) the or each exposed deposition surface area or areas is limited to such a size that under said chosen conditions of deposition said crystal forming material forms on the or each deposition surface area one single nucleus of supra-critical size which grows into one single crystal (7A; 7; 13A-1 and 13A-2).

**2.** The method of claim 1, where the difference in nucleation density between said deposition surface areas (6A;;9A; 12A-1 & 12A-2) and said adjacent deposition surface areas (5A;5A; 11A & 11-1A) is $10^3$-fold or above.

**3.** A method (fig.4; fig.7, fig.9, fig.12) as claimed in claims 1 or 2 wherein initially a thin film (6;12) of a material which forms said one or more deposition surface areas (6A;12A-1 & 12A-2), is deposited onto the substrate surface.

**4.** A method as claimed in claim 1 or 2 wherein said one or more deposition surface areas (6A;9A; 12A-1 & 12A-2) are of a material the composition of which has been modified by implanted ions.

**5.** A method as claimed in claim 4 wherein the step of establishing said one or more deposition surface areas (6A; 9A; 12A-1 & 12A-2) and adjacent deposition surface area (5A;5A; 11A & 11-1A) is performed by:

depositing a thin film (5;5;11) of material, which is to form said adjacent deposition surface area (5A;5A; 11A & 11-1A), onto the surface of said substrate (4;9;10) and opening one or more windows in said thin film (5;5; 11) by lithographic patterning using a resist; and
before said resist is removed, implanting ions in the substrate surface exposed by said one or more windows to produce said one or more deposition surface areas (6A; 9A; 12A-1 & 12A-2).

**6.** A method as claimed in any preceding claim wherein said adjacent deposition surface area (5A;5A; 11A & 11-1A) is of an amorphous material.

**7.** A method as claimed in any preceding claim wherein said one or more deposition surface areas (6A;9A; 12A-1 & 12A-2) are of an amorphous material.

**8.** A method as claimed in any of the preceding claims 1-7 wherein said one or more deposition surface areas (6A; 9A; 12A-1 & 12A-2) are of a polycrystalline material.

**9.** A method as claimed in claim 2 or 3, wherein said one or more deposition surface areas (6A;9A; 12A-1 & 12A-2) are of a metallic material.

**10.** A method as claimed in any preceding wherein said adjacent deposition surface area (5A;5A; 11A & 11-1A) is of silicon oxide material which may be either of stoichiometric composition $SiO_2$ or of non-stoichiometric composition $SiO_y$ $(0<y<2)$ and said crystal forming material is silicon.

**11.** A method as claimed in claim 10 wherein said one or more deposition surface areas (6A;9A; 12A-1 & 12A-2) are of silicon nitride material which may be either of stoichiometric composition $Si_3N_4$ or of non-stoichiometric composition $SiN_x$ $(0<x<4/3)$.

**12.** A method as claimed in claim 10 wherein said one or more deposition surface areas (6A,9A; 12A-1 & 12A-2) are of polycrystalline silicon.

**13.** A method as claimed in claims 4 or 5 wherein:

said one or more deposition surface areas (6A;9A; 12A-1 & 12A-2) are of either silicon oxide or polycrystalline silicon the composition of which has been modified by implanted ions of silicon or nitrogen;
said adjacent deposition surface area (5A;5A; 11A & 11-1A) is of silicon oxide; and
said crystal forming material is silicon.

**14.** A method as claimed in claim 4 or 5 wherein said one or more deposition surface areas (6A;9A; 12A-1 & 12A-2) are made from a silicon single crystal the composition of which has been modified by implanted ions of nitrogen, phosphorus, boron, fluorine, argon,helium, carbon, arsenic, gallium or germanium;

said adjacent deposition surface area (5A;5A; 11A & 11-1A) is of silicon oxide; and
said crystal forming material is silicon.

**15.** A method as claimed in claim 1 wherein said one or more deposition surface areas (6A;9A; 12A-1 & 12A-2) are of either tantalum oxide ($Ta_20_5$) or silicon oxynitride (SiON);

said adjacent deposition surface area (5A;5A; 11A & 11-1A) is of silicon oxide; and
said crystal forming material is silicon.

**16.** A method as claimed in claim 1 wherein said one or more deposition surface areas (6A; 9A; 12A-1 & 12A-2) are of any one of the metals copper, tungsten, tantalum, molybdenum, gold, titanium, aluminium or nickel, or alternatively any one of the semiconductor materials silicon, germanium, gallium arsenide, indium phosphide or silicon carbide;

said adjacent deposition surface area (5A;5A; 11A & 11-1A) is of either one of the metals iron or cobalt; and
said crystal forming material is carbon.

**17.** A method as claimed in claim 1 wherein:

said one or more deposition surface areas (6A;9A; 12A-1 & 12A-2) are of silicon, tungsten silicide, platinum silicide or aluminium;
said adjacent deposition surface area (5A;5A; 11A & 11-1A) is of silicon oxide; and
said crystal forming material is tungsten.

**18.** A method as claimed in claim 1 wherein said deposition and said further deposition are performed by a chemical vapour deposition process.

**19.** A method (fig.7; fig.12) as claimed in any one of the preceding claims, in which a plurality of deposition surface areas (12A-1, 12A-2) are provided, wherein said further deposition is continued until said single crystals (13-1, 13-2) contact each other and thus cover the surface of the substrate (10).

**20.** A method (fig.12(D)) as claimed in claim 19 wherein the free surface of said single crystals (13A-1 & 13A-2, 16) is planarised either by etching or by polishing.

**21.** A method (fig.7) as claimed in either of claims 19 or 20 wherein material-at the grain boundaries (14) at the meeting of said single crystals (13A-1, 13A-2) is removed to produce a plurality of spaced single crystal islets (15-1, 15-2).

**22.** A method (fig.10(A) as claimed in any of the preceding claims in which a plurality of deposition surface areas (12A-1, ...) are provided, these deposition surface areas (12A-1, ...) being spaced at regular intervals in at least one direction.

**23.** A method (fig. 10) as claimed in claim 23 wherein said deposition surface areas (12A-1, ...) are arranged as a regular two-dimensional array.

**24.** An article (fig.4(D), fig.5(B), fig.6(D), fig.7(D), fig.8(B), fig.9(C), fig.10(B), fig.11, fig. 12(D)), produced by a method as claimed in claim 1, which article comprises:

a substrate (4) having one or more amorphous or polycrystalline regions (6A);
a thin film or layer (5) above said substrate (4); and

one or more single crystals (7A,8) on said thin film or layer (5), which one or more single crystals (7A,8) respectively are in contact with said one or more amorphous or polycrystalline regions (6A) via a corresponding one or more respective windows provided in said thin film or layer (5) which article does not include as thin film or layer (5) a thin film or layer of material convertible by change of crystalline state to single crystal material lattice matched to the one or more single crystals.

**25.** An article (fig.12(D)) as claimed in claim 24 in which there is a plurality of single crystals (13A-1, 13A-2), these forming a polycrystalline thin film (16).

**26.** An article as claimed in either of the preceding claims 24 or 25 wherein:

each of said substrate regions (6A) is of silicon nitride of stoichiometric or non-stoichiometric composition, polycrystalline silicon, tantalum oxide or silicon oxynitride; or of polycrystalline silicon or silicon oxide implanted with ions of silicon or nitrogen;
said thin film or layer (5) is of silicon oxide of stoichiometric or non-stoichiometric composition; and
said one or more single crystals (7A,8) are of silicon.

**27.** An article produced by a method as claimed in claim 1, which article comprises:

a substrate (4);
a thin film or layer (5) above said substrate (4); and
one or more single crystals (7A,8) on said thin film or layer (5), which one or more single crystals (7A,8) are in contact with a respective one or more regions (6A) of said substrate (4) via a respective one or more windows provided in said thin film or layer (5); and wherein
each respective substrate region (6A) is one of the metals copper, tungsten, tantalum, molybdenum, gold, titanium, aluminium or nickel;
said thin film or layer (5) is of iron or cobalt; and
each of said single crystals (7A,8) is of diamond.

**28.** An article produced by a method as claimed in claim 1, which article comprises:

a substrate (4);
a thin film or layer (5) above said substrate (4); and
one or more single crystals (7A,8) on said thin film or layer (5), which one or more single crystals (7A,8) are in contact with a respective one or more regions (6A) of said substrate (4) via a respective one or more windows provided in said thin film or layer (5); and wherein:
each respective substrate region (6A) is one of the semiconductor materials silicon, germanium, gallium arsenide, indium phosphide or silicon carbide;
said thin film or layer (5) is of iron or cobalt; and
each of said single crystals (7A,8) is of diamond.

**29.** An article produced by a method as claimed in claim 1, which article comprises:

a substrate (4);
a thin film or layer (5) above said substrate (4); and
one or more single crystals (7A,8) or said thin film or layer (5), which one or more single crystals (7A,8) are in contact with a respective one or more regions (6A) of said substrate (4) via a respective one or more windows provided in said thin film or layer (5); and wherein
each respective substrate region (6A) is of silicon, tungsten silicide, platinum silicide or aluminium;
said thin film or layer (5) is of silicon oxide; and
each of said single crystals (7A,8) is of tungsten.

**30.** An article (fig.11) as claimed in claim 26 in which:

each said substrate region (1105) is of a thin film (1104) of silicon nitride on either silicon or gallium arsenide (1101);
said thin film or layer (1106) is of silicon oxide; and wherein
MOS transistors (1102, 1109) are provided both in said silicon or gallium arsenide material (1101) of the substrate (1101) and in a single crystal (1108) on said thin film (1104) of silicon nitride and thin film or layer (1106).

**31.** An article as claimed in claim 30 wherein complementary transistors (1102,1109) are provided in said silicon or gallium arsenide material (1101) of the substrate (1101) and in the single crystal (1108) respectively and are interconnected.

**32.** An article as claimed in claims 30 or 31, this being a stacked multilayer structure including at least one further thin film of silicon nitride above said single crystal, a thin film or layer of silicon oxide on said further thin film silicon region, and at least one further single crystal on said further thin film of silicon nitride and said thin film or layer of silicon oxide.

## Patentansprüche

**1.** Verfahren (Fig. 4; Fig. 6; Fig. 7; Fig. 9; Fig. 12) zur Herstellung eines oder mehr als eines Einkristalls (7A; 7; 13A-1 und 13A-2) aus einem kristallbildenden Material auf der Oberfläche eines Substrats (4; 9; 10), wobei bei diesem Verfahren

an einer freien Oberfläche des erwähnten Substrats ein oder mehr als ein Abscheidungsoberflächenbereich (6A; 9A; 12A-1 und 12A-2) hergestellt wird, der unter ausgewählten Abscheidungsbedingungen eine höhere Abscheidungsrate hat als der benachbarte Abscheidungsoberflächenbereich oder die benachbarten Abscheidungsoberflächenbereiche (5A; 11A und 11-1A), so daß sich das erwähnte kristallbildende Material selektiv auf dem erwähnten einen oder mehr als einen Abscheidungsoberflächenbereich (6A; 9A; 12A-1, 12A-2) abscheidet,

wobei bei dem Schritt der Herstellung des erwähnten einen oder mehr als einen Abscheidungsoberflächenbereichs (6A; 9A; 12A-1 und 12A-2) und eines benachbarten Abscheidungsoberflächenbereichs oder benachbarter Abscheidungsoberflächenbereiche (5A; 11A und 11-1A) auf der Oberfläche des erwähnten Substrats (4; 9; 10) ein Dünnfilm (5; 11) aus Material, das zur Bildung des erwähnten benachbarten Abscheidungsoberflächenbereichs oder der erwähnten benachbarten Abscheidungsoberflächenbereiche (5A; 11A und 11-1A) dient, abgeschieden wird und in dem erwähnten Dünnfilm durch photolithographische Strukturierung (einschließlich Röntgenlithographie) oder durch Strukturierung mit einem Elektronenstrahl oder Ionenstrahl ein oder mehr als ein Fenster geöffnet wird, wodurch der erwähnte eine oder mehr als eine Abscheidungsoberflächenbereich (6A; 9A; 12A-1 und 12A-2) über das erwähnte entsprechende eine oder mehr als eine Fenster in dem erwähnten benachbarten Abscheidungsoberflächenbereich oder in den erwähnten benachbarten Abscheidungsoberflächenbereichen (5A; 11A und 11-1A) freigelegt und dem erwähnten kristallbildenden Material ausgesetzt wird; und

das erwähnte kristallbildende Material unter den erwähnten ausgewählten Abscheidungsbedingungen auf der freigelegten freien Oberfläche (5A und 6A; 5A und 9A; 11A; 12A-1 und 12A-2) des erwähnten Substrats (4; 9; 10) abgeschieden wird; dadurch gekennzeichnet, daß

(a) der erwähnte eine oder mehr als eine Abscheidungsoberflächenbereich (6A; 9A; 12A-1 und 12A-2) Oberflächeneigenschaften hat, die ein epitaxiales Aufwachsen eines Einkristalls aus dem erwähnten kristallbildenden Material auf dem erwähnten einen oder mehr als einen Abscheidungsoberflächenbereich ausschließen;

(b) sich der Unterschied in den Abscheidungsraten ergibt, weil die Oberflächeneigenschaften des Abscheidungsoberflächenbereichs oder der Abscheidungsoberflächenbereiche und des benachbarten Oberflächenbereichs oder der benachbarten Oberflächenbereiche derart sind, daß sich in dem Abscheidungsoberflächenbereich oder in den Abscheidungsoberflächenbereichen eine höhere Zahl von Kristallkeimen pro Flächeneinheit bildet als in dem benachbarten Oberflächenbereich oder in den benachbarten Oberflächenbereichen; und

(c) der freigelegte Abscheidungsoberflächenbereich oder jeder freigelegte Abscheidungsoberflächenbereich auf eine derartige Größe beschränkt ist, daß das erwähnte kristallbildende Material unter den erwähnten ausgewählten Abscheidungsbedingungen auf dem Abscheidungsoberflächenbereich oder auf jedem Abscheidungsoberflächenbereich einen einzigen Kristallkeim mit überkritischer Größe bildet, der zu einem Einkristall (7A; 7; 13A-1 und 13A-2) heranwächst.

2. Verfahren nach Anspruch 1, bei dem sich die Keimbildungsdichte der erwähnten Abscheidungsoberflächenbereiche (6A; 9A; 12A-1 und 12A-2) derart von der Keimbildungsdichte der erwähnten benachbarten Abscheidungsoberflächenbereiche (5A; 5A; 11A und 11-1A) unterscheidet, daß sie das $10^3$fache oder mehr beträgt.

3. Verfahren (Fig. 4; Fig. 7, Fig. 9, Fig. 12) nach Anspruch 1 oder 2, bei dem auf der Substratoberfläche anfänglich ein Dünnfilm (6; 12) aus einem Material, das den erwähnten einen oder mehr als einen Abscheidungsoberflächenbereich (6A; 12A-1 und 12A-2) bildet, abgeschieden wird.

4. Verfahren nach Anspruch 1 oder 2, bei dem der erwähnte eine oder mehr als eine Abscheidungsoberflächenbereich (6A; 9A; 12A-1 und 12A-2) aus einem Material besteht, dessen Zusammensetzung durch implantierte Ionen modifiziert worden ist.

5. Verfahren nach Anspruch 4, bei dem der Schritt der Herstellung des erwähnten einen oder mehr als einen Abscheidungsoberflächenbereichs (6A; 9A; 12A-1 und 12A-2) und eines benachbarten Abscheidungsoberflächenbereichs (5A; 5A; 11A und 11-1A) durchgeführt wird, indem

   auf der Oberfläche des erwähnten Substrats (4; 9; 10) ein Dünnfilm (5; 5; 11) aus Material, das zur Bildung des erwähnten benachbarten Abscheidungsoberflächenbereichs (5A; 5A; 11A und 11-1A) dient, abgeschieden wird und in dem erwähnten Dünnfilm (5; 5; 11) durch lithographische Strukturierung unter Anwendung eines Resists ein oder mehr als ein Fenster geöffnet wird und

   in die Substratoberfläche, die durch das erwähnte eine oder mehr als eine Fenster freigelegt worden ist, vor der Entfernung des erwähnten Resists Ionen implantiert werden, um den erwähnten einen oder mehr als einen Abscheidungsoberflächenbereich (6A; 9A; 12A-1 und 12A-2) herzustellen.

6. Verfahren nach einem der vorhergehenden Ansprüche, bei dem der erwähnte benachbarte Abscheidungsoberflächenbereich (5A; 5A; 11A und 11-1A) aus einem amorphen Material besteht.

7. Verfahren nach einem der vorhergehenden Ansprüche, bei dem der erwähnte eine oder mehr als eine Abscheidungsoberflächenbereich (6A; 9A; 12A-1 und 12A-2) aus einem amorphen Material besteht.

8. Verfahren nach einem der vorhergehenden Ansprüche 1 bis 7, bei dem der erwähnte eine oder mehr als eine Abscheidungsoberflächenbereich (6A; 9A; 12A-1 und 12A-2) aus einem polykristallinen Material besteht.

9. Verfahren nach Anspruch 2 oder 3, bei dem der erwähnte eine oder mehr als eine Abscheidungsoberflächenbereich (6A; 9A; 12A-1 und 12A-2) aus einem metallischen Material besteht.

10. Verfahren nach einem der vorhergehenden Ansprüche, bei dem der erwähnte benachbarte Abscheidungsoberflächenbereich (5A; 5A; 11A und 11-1A) aus Siliciumoxidmaterial besteht, das entweder die stöchiometrische Zusammensetzung $SiO_2$ oder die nichtstöchiometrische Zusammensetzung $SiO_y$ ($0 < y < 2$) haben kann, und das erwähnte kristallbildende Material Silicium ist.

11. Verfahren nach Anspruch 10, bei dem der erwähnte eine oder mehr als eine Abscheidungsoberflächenbereich (6A; 9A; 12A-1 und 12A-2) aus Siliciumnitridmaterial besteht, das entweder die stöchiometrische Zusammensetzung $Si_3N_4$ oder die nichtstöchiometrische Zusammensetzung $SiN_x$ ($0 < x < 4/3$) haben kann.

12. Verfahren nach Anspruch 10, bei dem der erwähnte eine oder mehr als eine Abscheidungsoberflächenbereich (6A; 9A; 12A-1 und 12A-2) aus polykristallinem Silicium besteht.

13. Verfahren nach Anspruch 4 oder 5, bei dem

   der erwähnte eine oder mehr als eine Abscheidungsoberflächenbereich (6A; 9A; 12A-1 und 12A-2) entweder aus Siliciumoxid oder aus polykristallinem Silicium besteht, dessen Zusammensetzung durch implantierte Silicium- oder Stickstoffionen modifiziert worden ist;

   der erwähnte benachbarte Abscheidungsoberflächenbereich (5A; 5A; 11A und 11-1A) aus Siliciumoxid besteht und

das erwähnte kristallbildende Material Silicium ist.

**14.** Verfahren nach Anspruch 4 oder 5, bei dem

der erwähnte eine oder mehr als eine Abscheidungsoberflächenbereich (6A; 9A; 12A-1 und 12A-2) aus einem Silicium-Einkristall hergestellt ist, dessen Zusammensetzung durch implantierte Stickstoff-, Phosphor-, Bor-, Fluor-, Argon-, Helium-, Kohlenstoff-, Arsen-, Gallium- oder Germaniumionen modifiziert worden ist;

der erwähnte benachbarte Abscheidungsoberflächenbereich (5A; 5A; 11A und 11-1A) aus Siliciumoxid besteht und

das erwähnte kristallbildende Material Silicium ist.

**15.** Verfahren nach Anspruch 1, bei dem

der erwähnte eine oder mehr als eine Abscheidungsoberflächenbereich (6A; 9A; 12A-1 und 12A-2) entweder aus Tantaloxid ($Ta_2O_5$) oder aus Siliciumoxidnitrid (SioN) besteht;

der erwähnte benachbarte Abscheidungsoberflächenbereich (5A; 5A; 11A und 11-1A) aus Siliciumoxid besteht und

das erwähnte kristallbildende Material Silicium ist.

**16.** Verfahren nach Anspruch 1, bei dem

der erwähnte eine oder mehr als eine Abscheidungsoberflächenbereich (6A; 9A; 12A-1 und 12A-2) aus irgendeinem der Metalle Kupfer, Wolfram, Tantal, Molybdän, Gold, Titan, Aluminium oder Nickel oder alternativ aus irgendeinem der Halbleitermaterialien Silicium, Germanium, Galliumarsenid, Indiumphosphid oder Siliciumcarbid besteht;

der erwähnte benachbarte Abscheidungsoberflächenbereich (5A; 5A; 11A und 11-1A) aus einem der Metalle Eisen und Cobalt besteht und

das erwähnte kristallbildende Material Kohlenstoff ist.

**17.** Verfahren nach Anspruch 1, bei dem

der erwähnte eine oder mehr als eine Abscheidungsoberflächenbereich (6A; 9A; 12A-1 und 12A-2) aus Silicium, Wolframsilicid, Platinsilicid oder Aluminium besteht;

der erwähnte benachbarte Abscheidungsoberflächenbereich (5A; 5A; 11A und 11-1A) aus Siliciumoxid besteht und

das erwähnte kristallbildende Material Wolfram ist.

**18.** Verfahren nach Anspruch 1, bei dem die erwähnte Abscheidung und die erwähnte weitere Abscheidung durch ein chemisches Aufdampfungsverfahren durchgeführt werden.

**19.** Verfahren (Fig. 7; Fig. 12) nach einem der vorhergehenden Ansprüche, bei dem mehr als ein Abscheidungsoberflächenbereich (12A-1, 12A-2) bereitgestellt wird, wobei die erwähnte weitere Abscheidung fortgesetzt wird, bis die erwähnten Einkristalle (13-1, 13-2) einander berühren und somit die Oberfläche des Substrats (10) bedecken.

**20.** Verfahren [Fig. 12(D)] nach Anspruch 19, bei dem die freie Oberfläche der erwähnten Einkristalle (13A-1 und 13A-2, 16) entweder durch Ätzen oder durch Polieren geebnet wird.

**21.** Verfahren (Fig. 7) nach Anspruch 19 oder 20, bei dem Material an den Korngrenzen (14) an den Stellen, wo die erwähnten Einkristalle (13A-1, 13A-2) aneinanderstoßen, entfernt wird, um mehr als eine mit Abstand angeordnete Einkristallinsel (15-1, 15-2) herzustellen.

**22.** Verfahren [Fig. 10(A)] nach einem der vorhergehenden Ansprüche, bei dem mehr als ein Abscheidungsoberflächenbereich (12A-1, ...) bereitgestellt wird, wobei diese Abscheidungsoberflächenbereiche (12A-1, ...) in mindestens einer Richtung mit regelmäßigen Abständen angeordnet sind.

**23.** Verfahren (Fig. 10) nach Anspruch 22, bei dem die erwähnten Abscheidungsoberflächenbereiche (12A-1, ...) als regelmäßige zweidimensionale Anordnung angeordnet sind.

**24.** Gegenstand [Fig. 4(D), Fig. 5(B), Fig. 6(D), Fig. 7(D), Fig. 8(B), Fig. 9(C), Fig. 10(B), Fig. 11, Fig. 12(D)], der durch ein Verfahren nach Anspruch 1 hergestellt worden ist, wobei dieser Gegenstand

ein Substrat (4) mit einem oder mehr als einem amorphen oder polykristallinen Bereich (6A);

einen Dünnfilm oder eine Schicht (5), die sich über dem erwähnten Substrat (4) befindet; und

einen oder mehr als einen Einkristall (7A, 8), der sich auf dem erwähnten Dünnfilm oder der erwähnten Schicht (5) befindet, umfaßt, wobei dieser eine oder mehr als eine Einkristall (7A, 8) jeweils über ein oder mehr als ein entsprechendes jeweiliges Fenster, das in dem erwähnten Dünnfilm oder der erwähnten Schicht (5) bereitgestellt ist, mit dem erwähnten einen oder mehr als einen amorphen oder polykristallinen Bereich (6A) in Kontakt ist, wobei dieser Gegenstand als Dünnfilm oder Schicht (5) keinen Dünnfilm oder keine Schicht aus einem Material einschließt, das durch Änderung des kristallinen Zustands in Einkristallmaterial umgewandelt werden kann, dessen Gitter an den einen oder mehr als einen Einkristall angepaßt ist.

**25.** Gegenstand [Fig. 12(D)] nach Anspruch 24, in dem mehr als ein Einkristall (13A-1, 13A-2) vorhanden ist, wobei diese einen polykristallinen Dünnfilm (16) bilden.

**26.** Gegenstand nach einem der vorhergehenden Ansprüche 24 und 25, bei dem

jeder der erwähnten Substratbereiche (6A) aus Siliciumnitrid mit stöchiometrischer oder nichtstöchiometrischer Zusammensetzung, polykristallinem Silicium, Tantaloxid oder Siliciumoxidnitrid oder aus polykristallinem Silicium oder Siliciumoxid, in das Silicium- oder Stickstoffionen implantiert worden sind, besteht;

der erwähnte Dünnfilm oder die erwähnte Schicht (5) aus Siliciumoxid mit stöchiometrischer oder nichtstöchiometrischer Zusammensetzung besteht und

der erwähnte eine oder mehr als eine Einkristall (7A, 8) aus Silicium besteht.

**27.** Gegenstand, der durch ein Verfahren nach Anspruch 1 hergestellt worden ist, wobei dieser Gegenstand

ein Substrat (4);

einen Dünnfilm oder eine Schicht (5), die sich über dem erwähnten Substrat (4) befindet; und

einen oder mehr als einen Einkristall (7A, 8), der sich auf dem erwähnten Dünnfilm oder der erwähnten Schicht (5) befindet, umfaßt, wobei dieser eine oder mehr als eine Einkristall (7A, 8) über ein oder mehr als ein jeweiliges Fenster, das in dem erwähnten Dünnfilm oder der erwähnten Schicht (5) bereitgestellt ist, mit einem oder mehr als einem jeweiligen Bereich (6A) des erwähnten Substrats (4) in Kontakt ist und wobei

jeder jeweilige Substratbereich (6A) eines der Metalle Kupfer, Wolfram, Tantal, Molybdän, Gold, Titan, Aluminium oder Nickel ist;

der erwähnte Dünnfilm oder die erwähnte Schicht (5) aus Eisen oder Cobalt besteht und

jeder der erwähnten Einkristalle (7A, 8) aus Diamant besteht.

**28.** Gegenstand, der durch ein Verfahren nach Anspruch 1 hergestellt worden ist, wobei dieser Gegenstand ein Substrat (4);

einen Dünnfilm oder eine Schicht (5), die sich über dem erwähnten Substrat (4) befindet; und

einen oder mehr als einen Einkristall (7A, 8), der sich auf dem erwähnten Dünnfilm oder der erwähnten Schicht (5) befindet, umfaßt, wobei dieser eine oder mehr als eine Einkristall (7A, 8) über ein oder mehr als ein jeweiliges Fenster, das in dem erwähnten Dünnfilm oder der erwähnten Schicht (5) bereitgestellt ist, mit einem oder mehr als einem jeweiligen Bereich (6A) des erwähnten Substrats (4) in Kontakt ist und wobei

jeder jeweilige Substratbereich (6A) eines der Halbleitermaterialien Silicium, Germanium, Galliumarsenid, Indiumphosphid oder Siliciumcarbid ist;

der erwähnte Dünnfilm oder die erwähnte Schicht (5) aus Eisen oder Cobalt besteht und

jeder der erwähnten Einkristalle (7A, 8) aus Diamant besteht.

**29.** Gegenstand, der durch ein Verfahren nach Anspruch 1 hergestellt worden ist, wobei dieser Gegenstand

ein Substrat (4);

einen Dünnfilm oder eine Schicht (5), die sich über dem erwähnten Substrat (4) befindet; und

einen oder mehr als einen Einkristall (7A, 8), der sich auf dem erwähnten Dünnfilm oder der erwähnten Schicht (5) befindet, umfaßt, wobei dieser eine oder mehr als eine Einkristall (7A, 8) über ein oder mehr als ein jeweiliges Fenster, das in dem erwähnten Dünnfilm oder der erwähnten Schicht (5) bereitgestellt ist, mit einem oder mehr als einem jeweiligen Bereich (6A) des erwähnten Substrats (4) in Kontakt ist und wobei

jeder jeweilige Substratbereich (6A) aus Silicium, Wolframsilicid, Platinsilicid oder Aluminium besteht;

der erwähnte Dünnfilm oder die erwähnte Schicht (5) aus Siliciumoxid besteht und

jeder der erwähnten Einkristalle (7A, 8) aus Wolfram besteht.

**30.** Gegenstand (Fig. 11) nach Anspruch 26, bei dem

jeder erwähnte Substratbereich (1105) aus einem Dünnfilm (1104) aus Siliciumnitrid auf entweder Silicium oder Galliumarsenid (1101) besteht und

der erwähnte Dünnfilm oder die erwähnte Schicht (1106) aus Siliciumoxid besteht und bei dem

sowohl in dem erwähnten Silicium- oder Galliumarsenidmaterial (1101) des Substrats (1101) als auch in einem Einkristall (1108), der sich auf dem erwähnten Dünnfilm (1104) aus Siliciumnitrid und dem Dünnfilm oder der Schicht (1106) befindet, MOS-Transistoren (1102, 1109) bereitgestellt sind.

**31.** Gegenstand nach Anspruch 30, bei dem in dem erwähnten Silicium- oder Galliumarsenidmaterial (1101) des Substrats (1101) bzw. in dem Einkristall (1108) Komplementärtransistoren (1102, 1109) bereitgestellt und miteinander verbunden sind.

**32.** Gegenstand nach Anspruch 30 oder 31, wobei dieser eine gestapelte Mehrschichtstruktur ist, die mindestens einen weiteren Dünnfilm aus Siliciumnitrid, der sich über dem erwähnten Einkristall befindet, einen Dünnfilm oder eine Schicht aus Siliciumoxid, die sich auf dem erwähnten weiteren Dünnfilm-Siliciumbereich befindet, und mindestens einen weiteren Einkristall, der sich auf dem erwähnten weiteren Dünnfilm aus Siliciumnitrid und dem erwähnten Dünnfilm oder der erwähnten Schicht aus Siliciumoxid befindet, einschließt.

**Revendications**

**1.** Procédé (figure 4 ; figure 6 ; figure 7 ; figure 9 figure 12) de production, à la surface d'un substrat (4 ; 9 ; 10) d'un ou plusieurs monocristaux (7A ; 7 ; 13A-1 et 13A-2) d'une matière formant un cristal, procédé qui comprend :

l'établissement, sur une surface libre du substrat en question, d'une ou plusieurs aires de dépôt (6A ; 9A ; 12A-1 et 12A-2) ayant, dans des conditions choisies de dépôt, une plus grande vitesse de dépôt que l'aire ou les aires de dépôt adjacentes (5A ; 11A et 11-1A) de manière que cette matière formant un cristal se dépose sélectivement sur cette ou ces aires de dépôt (6A ; 9A ; 12A-1, 12A-2),
où l'étape d'établissement de cette aire ou ces aires de dépôt (6A ; 9A ; 12A-1 et 12A-2) et l'aire ou les aires de dépôt adjacentes (5A ; 11A et 11-1A) comprend le dépôt d'un mince film (5 ; 11) de matière qui doit former cette aire ou ces aires de dépôt adjacentes (5A ; 11A et 11-1A) sur la surface dudit substrat (4 ; 9 ; 10) et l'ouverture d'une ou plusieurs fenêtres dans le mince film en question par formation de motifs photolithographiques (y compris la lithographie aux rayons X) ou par formation de motifs avec un faisceau d'électrons ou un faisceau d'ions de manière que cette aire ou ces aires de dépôt (6A ; 9A ; 12A-1, 12A-2) soient exposées à la matière de formation d'un cristal par la fenêtre ou plusieurs fenêtres correspondantes ouvertes dans l'aire ou les aires de dépôt adjacentes (5A ; 11A et 11-1A) ; et
dépôt de la matière formant un cristal sur la surface libre exposée (5A et 6A ; 5A et 9A ; 11A ; 12A-1 et 12A-2) dudit substrat (4 ; 9; 10) dans les conditions choisies de dépôt indiquées ;

caractérisé en ce que

(a) l'aire ou les aires de dépôt en question (6A ; 9A ; 12A-1 et 12A-2) ont des propriétés de surface qui excluent une croissance épitaxiale d'un monocristal de la matière en question formant un cristal sur l'aire ou les aires de dépôt ;
(b) la différence des vitesses de dépôt provient du fait que les propriétés de surface de l'aire ou des aires de dépôt et de l'aire ou des aires adjacentes est telle que le nombre de noyaux formés par unité de surface dans l'aire ou les aires de dépôt est plus grand que dans l'aire ou les aires adjacentes ; et
(c) l'aire de dépôt ou chacune des aires de dépôt exposées est limitée à des dimensions telles que dans les conditions choisies de dépôt, la matière formant un cristal en question forme sur l'aire ou sur chaque aire de dépôt un noyau unique de dimensions supra-critiques qui se développe en formant un monocristal (7A ; 7 ; 13A-1 et 13A-2).

**2.** Procédé suivant la revendication 1, dans lequel la différence de densité de nucléation entre lesdites aires de dépôt (6A ; 9A ; 12A-1 et 12A-2) et lesdites aires de dépôt adjacentes (5A;5A ; 11A et 11-1A) atteint ou dépasse un facteur $10^3$.

**3.** Procédé (figure 4 ; figure 7 ; figure 9 ; figure 12) suivant la revendication 1 ou 2, dans lequel un mince film (6 ; 12) d'une matière qui forme l'aire ou les aires de dépôt en question (6A ; 12A-1, et 12A-2) est initialement déposé à la surface du substrat.

**4.** Procédé suivant la revendication 1 ou 2, dans lequel l'aire ou les aires de dépôt en question (6A ; 9A ; 12A-1 et 12A-2) sont en une matière dont la composition a été modifiée par des ions implantés.

**5.** Procédé suivant la revendication 4, dans lequel l'étape d'établissement d'une ou plusieurs aires de dépôt (6A ; 9A ; 12A-1 et 12A-2) et de l'aire de dépôt adjacente (5A;5A ; 11A et 11-1A) est conduite par :

dépôt d'un mince film (5 ; 5 ; 11) de matière qui doit former ladite aire de dépôt adjacente (5A;5A ; 11A et 11-1A) sur la surface dudit substrat (4 ; 9 ;10) et l'ouverture d'une ou plusieurs fenêtres dans ce mince film (5 ; 5 ; 11) par formation d'un motif lithographique en utilisant une réserve ; et
avant l'enlèvement de cette réserve, implantation d'ions dans la surface du substrat exposée par ladite fenêtre ou lesdites fenêtres pour produire l'aire ou les aires de dépôt en question (6A ; 9A ; 12A-1 et 12A-2).

**6.** Procédé suivant l'une quelconque des revendications précédentes, dans lequel l'aire de dépôt adjacente (5A;5A ; 11A et 11-1A) est en une matière amorphe.

**7.** Procédé suivant l'une quelconque des revendications précédentes, dans lequel l'aire ou les aires de dépôt en question (6A ; 9A ; 12A-1 et 12A-2) sont en matière amorphe.

**8.** Procédé selon l'une quelconque des revendications 1 à 7 précédentes, dans lequel l'aire ou les aires de dépôt en question (6A ; 9A ; 12A-1 et 12A-2) sont en une matière polycristalline.

9. Procédé suivant la revendication 2 ou 3, dans lequel l'aire ou les aires de dépôt en question (6A ; 9A ; 12A-1 et 12A-2) sont en une matière métallique.

10. Procédé suivant l'une quelconque des revendications précédentes, dans lequel l'aire de dépôt adjacente (5A;5A ; 11A et 11-1A) est en une matière formée d'oxyde de silicium qui peut être de composition stoechiométrique $SiO_2$ ou de composition non stoechiométrique $SiO_y$ ($0<y<2$) et la matière formant un cristal est du silicium.

11. Procédé suivant la revendication 10, dans lequel l'aire ou les aires de dépôt (6A ; 9A ; 12A-1 et 12A-2) sont en nitrure de silicium qui peut être de composition stoechiométrique $Si_3N_4$ ou de composition non stoechiométrique $SiN_x$ ($0<x<4/3$) .

12. Procédé suivant la revendication 10, dans lequel l'aire ou les aires de dépôt (6A ; 9A ; 12A-1 et 12A-2) sont en silicium polycristallin.

13. Procédé suivant la revendication 4 ou 5, dans lequel :

    l'aire ou les aires de dépôt (6A ; 9A ; 12A-1 et 12A-2) sont en oxyde de silicium ou en silicium polycristallin dont la composition a été modifiée par des ions implantés de silicium ou d'azote ;
    l'aire de dépôt adjacente (5A;5A ; 11A et 11-1A) est en oxyde de silicium ; et
    la matière formant un cristal est du silicium.

14. Procédé suivant la revendication 4 ou 5, dans lequel l'aire ou les aires de dépôt (6A ; 9A ; 12A-1 et 12A-2) sont formés à partir d'un monocristal de silicium dont la composition a été modifiée par des ions implantés d'azote, de phosphore, de bore, de fluor, d'argon, d'hélium, de carbone, d'arsenic, de gallium ou de germanium ;

    l'aire de dépôt adjacente (5A;5A ; 11A et 11-1A) est en oxyde de silicium ; et
    la matière formant un cristal est du silicium.

15. Procédé suivant la revendication 1, dans lequel l'aire ou les aires de dépôt (6A ; 9A ; 12A-1 et 12A-2) sont en oxyde de tantale ($Ta_2O_5$) ou en oxynitrure de silicium (SiON) ;

    l'aire de dépôt adjacente (5A;5A ; 11A et 11-1A) est en oxyde de silicium ; et
    la matière formant un cristal est du silicium.

16. Procédé suivant la revendication 1, dans lequel l'aire ou les aires de dépôt (6A ; 9A ; 12A-1 et 12A-2) sont en l'un quelconque des métaux cuivre, tungstène, tantale, molybdène, or, titane, aluminium ou nickel, ou bien en variante en l'une quelconque des matières semiconductrices silicium, germanium, arséniure de gallium, phosphure d'indium et carbure de silicium ;

    l'aire de dépôt adjacente (5A;5A ; 11A et 11-1A) est en l'un ou l'autre des métaux fer et cobalt, et
    la matière formant un cristal est du carbone.

17. Procédé suivant la revendication 1, dans lequel :

    l'aire ou les aires de dépôt (6A ; 9A ; 12A-1 et 12A-2) sont en silicium, siliciure de tungstène, siliciure de platine ou aluminium ;
    l'aire de dépôt adjacente (5A;5A ; 11A et 11-1A) est en oxyde de silicium ; et
    la matière formant un cristal est le tunsgtène.

18. Procédé suivant la revendication 1, dans lequel le dépôt et l'autre dépôt en question sont effectués par un procédé de dépôt chimique en phase vapeur.

19. Procédé (figure 7 ; figure 12) suivant l'une quelconque des revendications précédentes, dans lequel plusieurs aires de dépôt (12A-1, 12A-2) sont prévues, l'autre dépôt en question étant poursuivi jusqu'à ce que lesdits monocristaux (13-1, 13-2) soient au contact les uns des autres et recouvrent ainsi la surface du substrat (10).

20. Procédé (figures 12(D)) suivant la revendication 19, dans lequel la surface libre des monocristaux (13A-1 et 13A-2, 16) est rendue plane par attaque chimique ou par polissage.

**21.** Procédé (figure 7) suivant l'une des revendications 19 ou 20, dans lequel la matière aux limites (14) des grains à la rencontre desdits monocristaux (13A-1, 13A-2) est enlevée pour produire une pluralité d'îlots monocristallins (15-1, 15-2) espacés.

**22.** Procédé (figure 10(A)) suivant l'une quelconque des revendications précédentes, dans lequel plusieurs aires de dépôt (12A-1, ...) sont prévues, ces aires de dépôt (12A-1, ...) étant espacées à des intervalles réguliers dans au moins une direction.

**23.** Procédé (figure 10) suivant la revendication 23, dans lequel les aires de dépôt (12A-1, ...) sont agencées en un ensemble régulier bidimensionnel.

**24.** Article (figure 4(D), figure 5(B), figure 6(D), figure 7(D), figure 8(B), figure 9(C), figure 10(B), figure 11, figure 12 (D)) produit par un procédé suivant la revendication 1, cet article comprenant :

un substrat (4) présentant une ou plusieurs régions (6A) amorphes ou polycristallines ;
un mince film ou couche (5) au-dessus dudit substrat (4) et
un ou plusieurs monocristaux (7A,8) sur ce mince film ou cette mince couche (5), le monocristal ou les monocristaux (7A,8) se trouvant respectivement au contact de la région ou des régions amorphes ou polycristallines (6A) par l'intermédiaire d'une ou plusieurs fenêtres respectives correspondantes ménagées dans le mince film ou la mince couche (5), cet article ne comportant pas, comme mince film ou mince couche (5), un mince film ou une mince couche d'une matière pouvant être convertie, par modification de l'état cristallin, en réseau de matière à monocristal adapté au monocristal ou aux monocristaux en question.

**25.** Article (figure 12(D)) suivant la revendication 24, dans lequel il y a plusieurs monocristaux (13A-1, 13A-2) formant un mince film polycristallin (16).

**26.** Article suivant l'une ou l'autre des revendications 24 ou 25 précédentes, dans lequel :

chacune desdites régions de substrat (6) est en nitrure de silicium de composition stoechiométrique ou non stoechiométrique, silicium polycristallin, oxyde de tantale ou oxynitrure de silicium ; ou en silicium polycristallin ou oxyde de silicium avec implantation d'ions de silicium ou d'azote ;
le mince film ou la mince couche (5) est en oxyde de silicium de composition stoechiométrique ou non stoechiométrique et
le monocristal ou les monocristaux (7A,8) sont en silicium.

**27.** Article produit par un procédé suivant la revendication 1, qui comprend :

un substrat (4) ;
un mince film ou une mince couche (5) sur ledit substrat (4) ; et
un ou plusieurs monocristaux (7A,8) sur le mince film ou la mince couche (5) en question, le monocristal ou les monocristaux (7A,8) étant en contact avec une ou plusieurs régions respectives (6A) dudit substrat (4) par l'intermédiaire d'une ou plusieurs fenêtres respectives prévues dans le mince film ou la mince couche (5) ; et dans lequel
chaque région respective (6A) du substrat est formée de l'un des métaux cuivre, tungstène, tantale, molybdène, or, titane, aluminium ou nickel ;
le mince film ou la mince couche (5) est en fer ou en cobalt ; et
chacun des monocristaux (7A,8) est en diamant.

**28.** Article produit par un procédé suivant la revendication 1, cet article comprenant :

un substrat (4) ;
un mince film ou une mince couche (5) sur ledit substrat (4) ; et
un ou plusieurs monocristaux (7A,8) sur le mince film ou la mince couche (5), le monocristal ou les monocristaux (7A,8) étant en contact avec une ou plusieurs régions respectives (6A) dudit substrat (4) par l'intermédiaire d'une ou plusieurs fenêtres respectives prévues dans le mince film ou la mince couche (5) ; et dans lequel :
chaque région respective (6A) du substrat en une des matières semiconductrices silicium, germanium, arséniure de gallium, phosphure d'indium ou carbure de silicium ;
le mince film ou la mince couche (5) est en fer ou en cobalt et

chacun desdits monocristaux (7A,8) est en diamant.

**29.** Article produit par un procédé suivant la revendication 1, cet article comprenant :

un substrat (4) ;
un mince film ou une mince couche (5) sur ledit substrat (4) ; et
un ou plusieurs monocristaux (7A,8) sur le mince film ou la mince couche (5), le monocristal ou les monocristaux (7A,8) étant en contact avec une ou plusieurs régions respectives (6A) dudit substrat (4) par l'intermédiaire d'une ou plusieurs fenêtres respectives prévues dans le mince film ou la mince couche (5) ; et dans lequel
chaque région respective du substrat (6A) est en silicium, siliciure de tungstène, siliciure de platine ou aluminium ;
le mince film ou la mince couche (5) est en oxyde de silicium ; et
chacun des monocristaux (7A,6) est en tungstène.

**30.** Article (figure 11) suivant la revendication 26, dans lequel :

chaque région (1105) du substrat est formée d'un mince film (1104) de nitrure de silicium sur du silicium ou de l'arséniure de gallium (1101) ;
le mince film ou la mince couche (1106) est en oxyde de silicium ; et
des transistors MOS (1102, 1109) sont prévus à la fois dans le silicium ou l'arséniure de gallium (1101) du substrat (1101) et dans un monocristal (1108) se trouvant sur le mince film (1104) de nitrure de silicium et le mince film ou la mince couche (1106).

**31.** Article suivant la revendication 30, dans lequel des transistors complémentaires (1102, 1109) sont prévus dans la matière en silicium ou arséniure de gallium (1101) du substrat (1101) et respectivement dans le monocristal (1108) et sont interconnectés.

**32.** Article suivant la revendication 30 ou 31, présentant une structure à empilement multicouche comprenant au moins un autre mince film de nitrure de silicium par dessus le monocristal, un mince film ou une mince couche d'oxyde de silicium sur l'autre région de silicium en mince film et au moins un autre monocristal sur l'autre mince film de nitrure de silicium et le mince film ou la mince couche d'oxyde de silicium.

Fig. 1

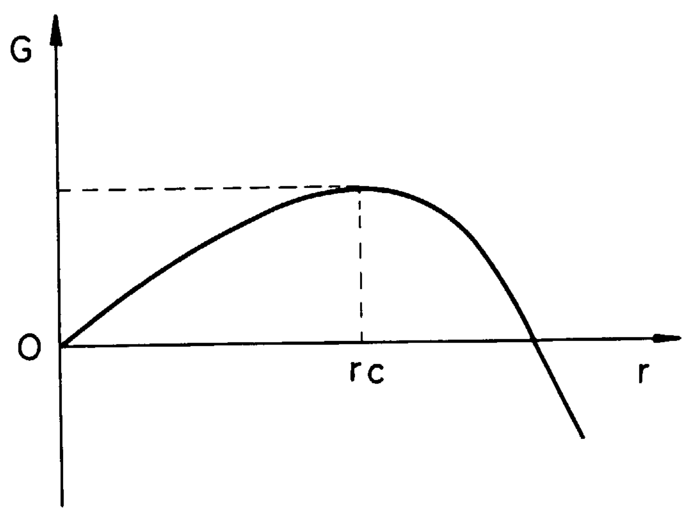

Fig. 2

(A)

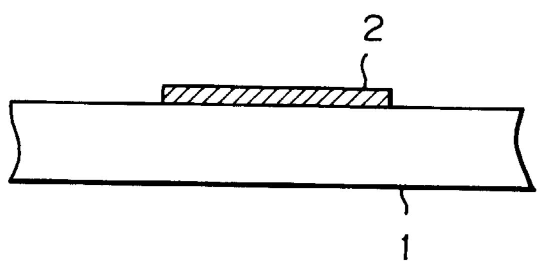


(B)

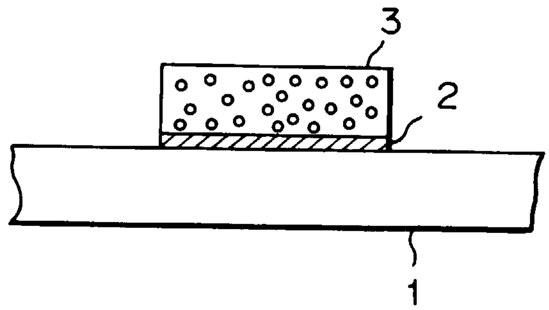

*Fig. 3*

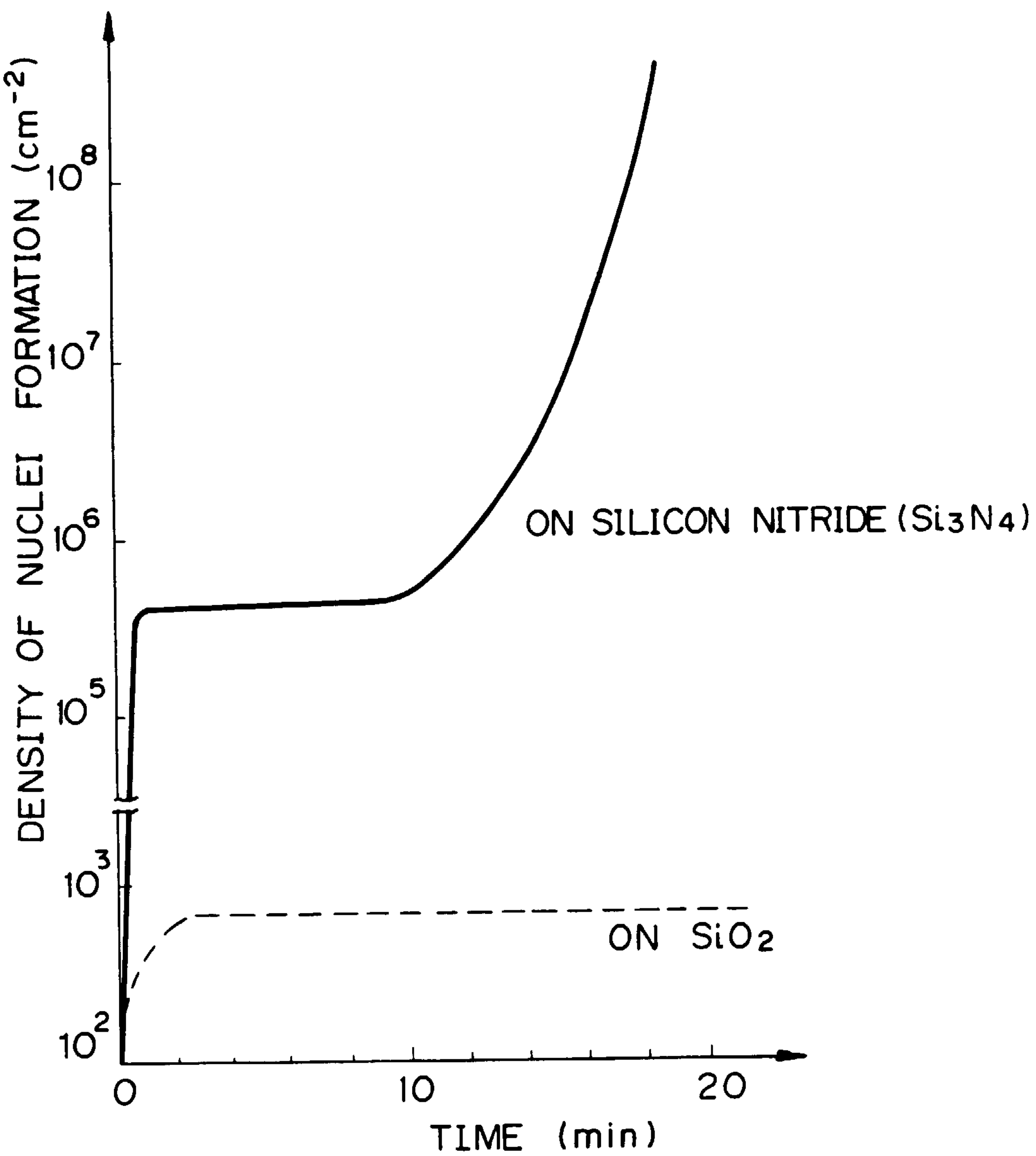
DENSITY OF NUCLEI FORMATION (cm^-2)
10^8
10^7
10^6
10^5
10^3
10^2
ON SILICON NITRIDE (Si3N4)
ON SiO2
0
10
20
TIME (min)

Fig. 4

(A)

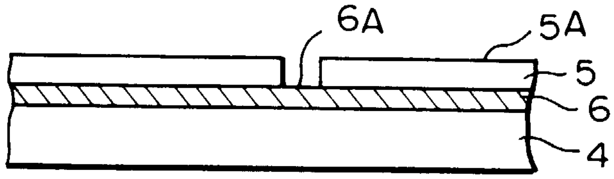


(B)

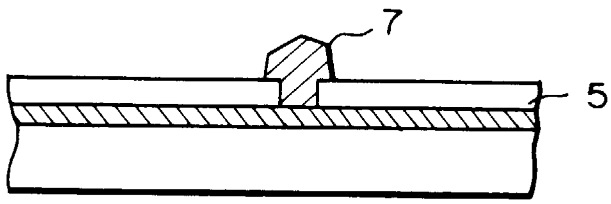


(C)

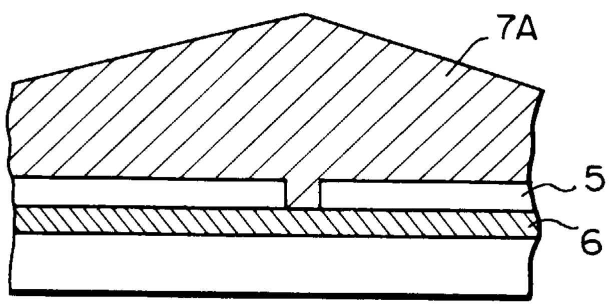


(D)

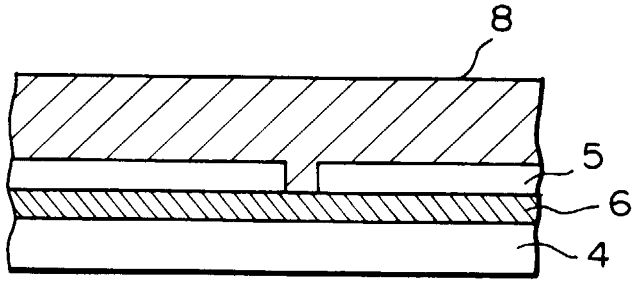

*Fig. 5*

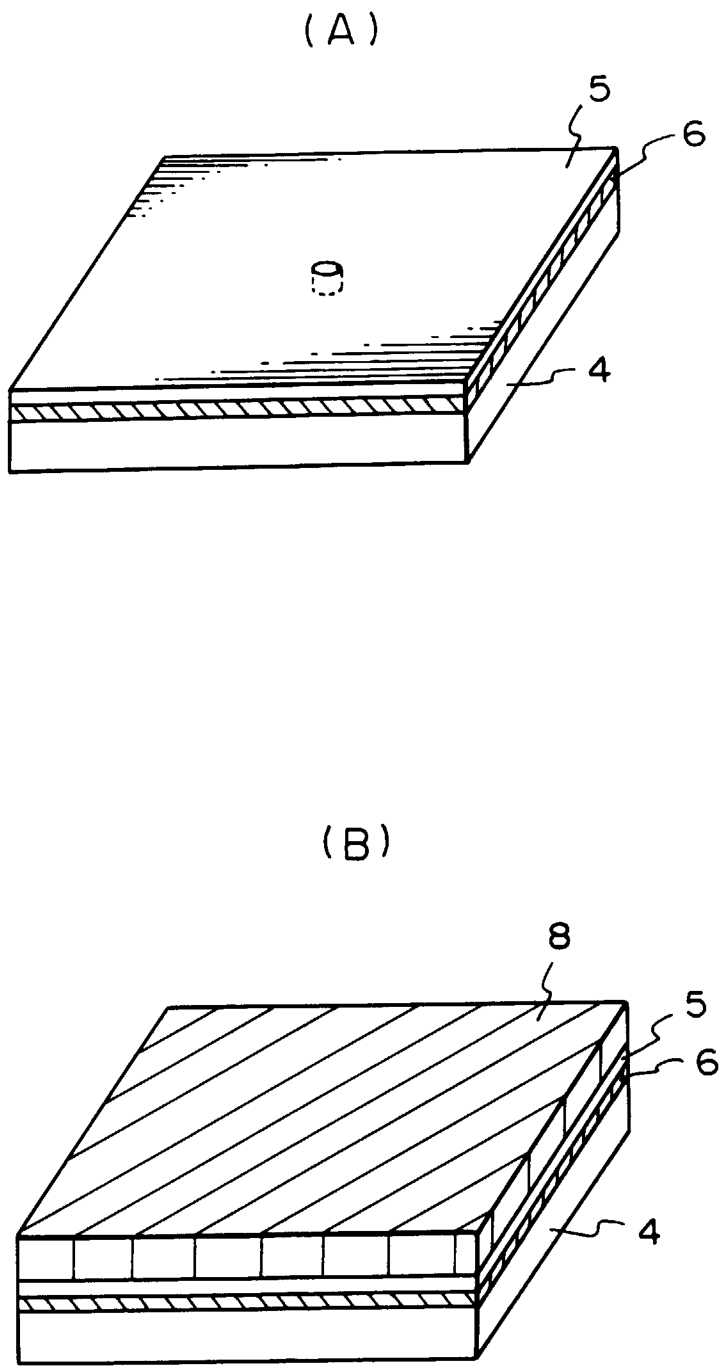

Fig. 6

(A)

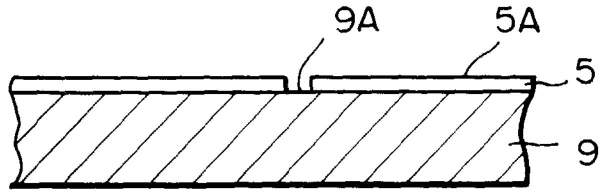


(B)

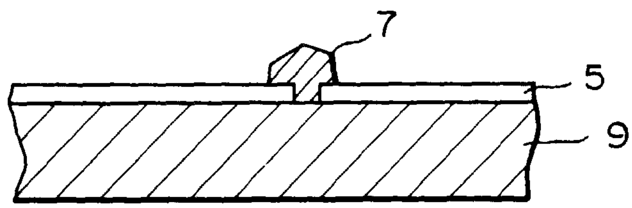


(C)

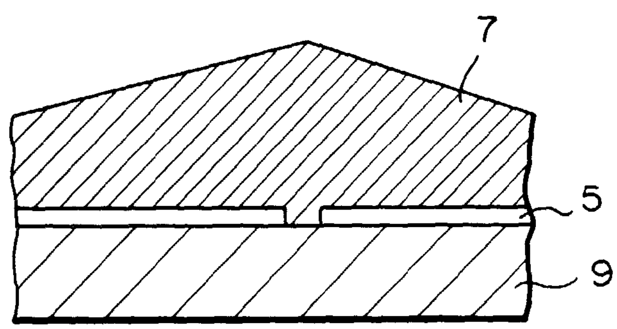


(D)

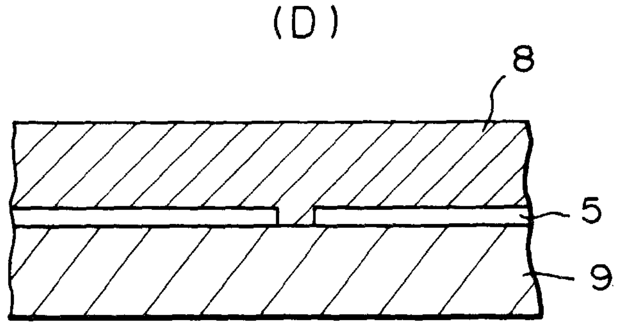

Fig. 7

(A)

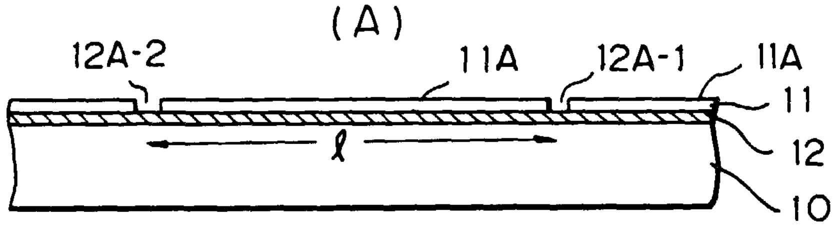
12A-2
11A
12A-1
11A
11
12
10
ℓ

(B)

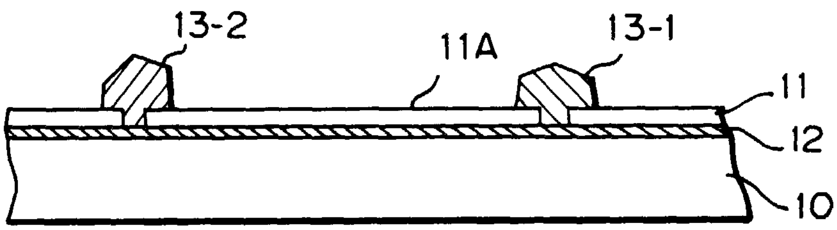
13-2
11A
13-1
11
12
10

(C)

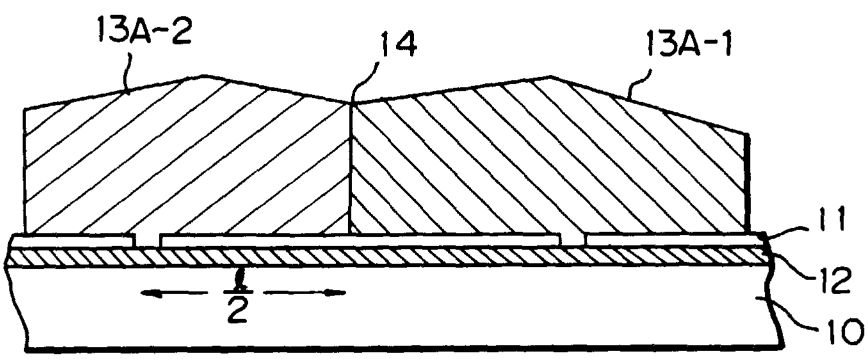
13A-2
14
13A-1
11
12
10
ℓ/2

(D)

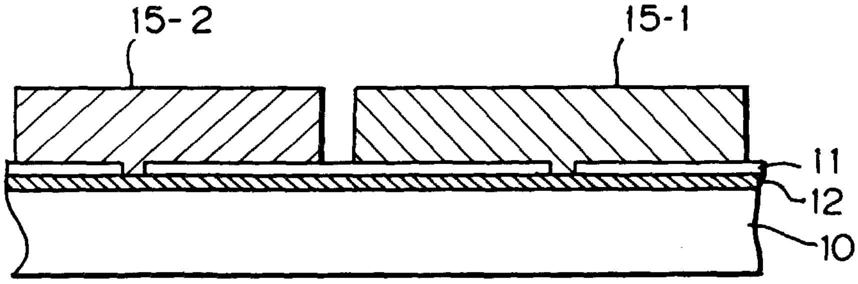
15-2
15-1
11
12
10

Fig. 8

(A)

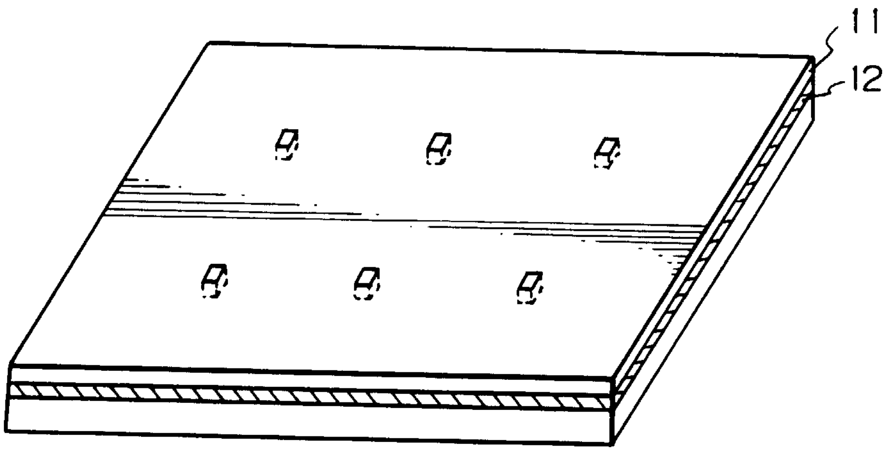


(B)

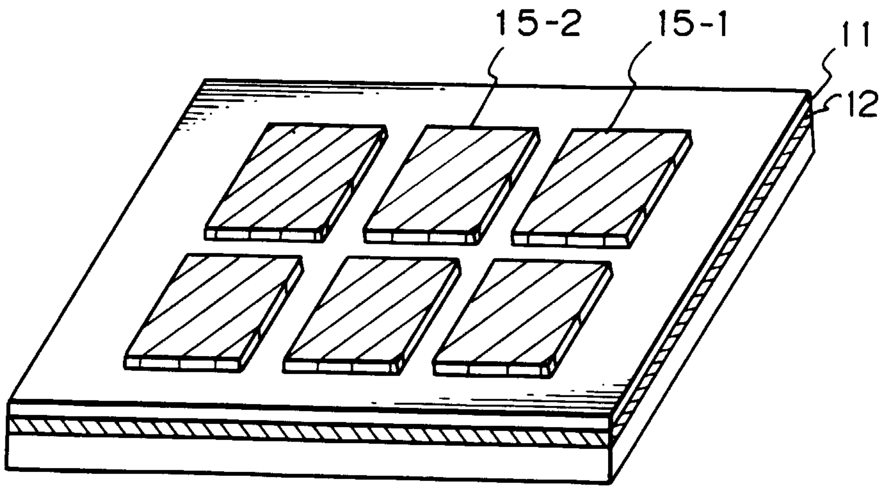

Fig. 9

(A)

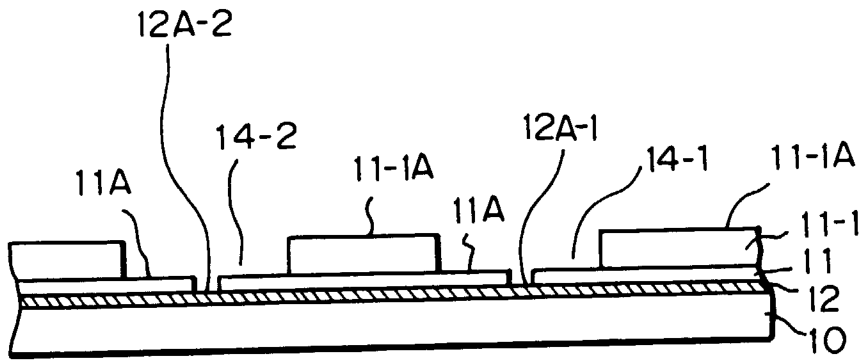


(B)

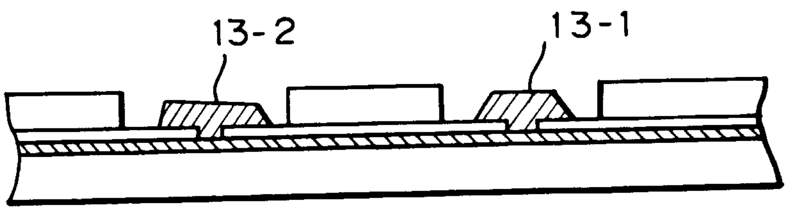


(C)

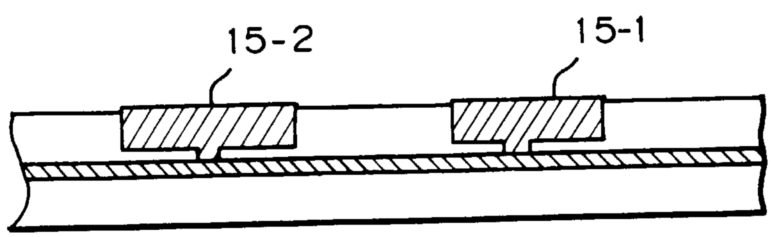

Fig. 10

(A)

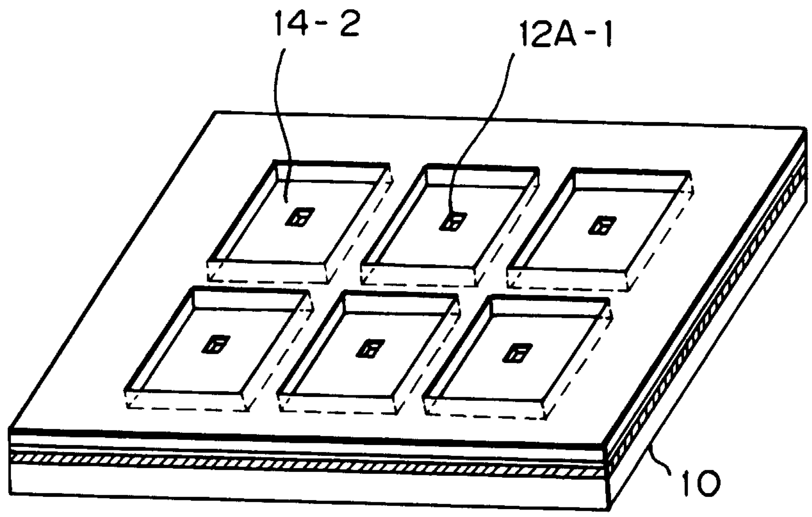


(B)

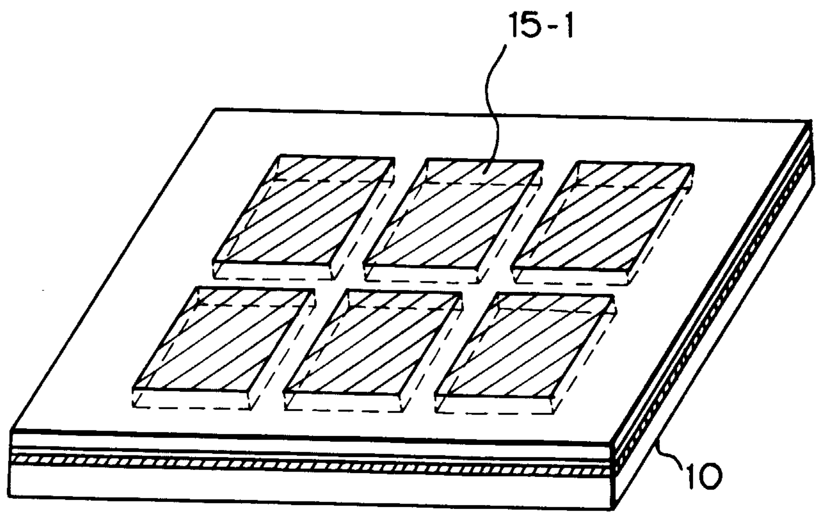

Fig. 11

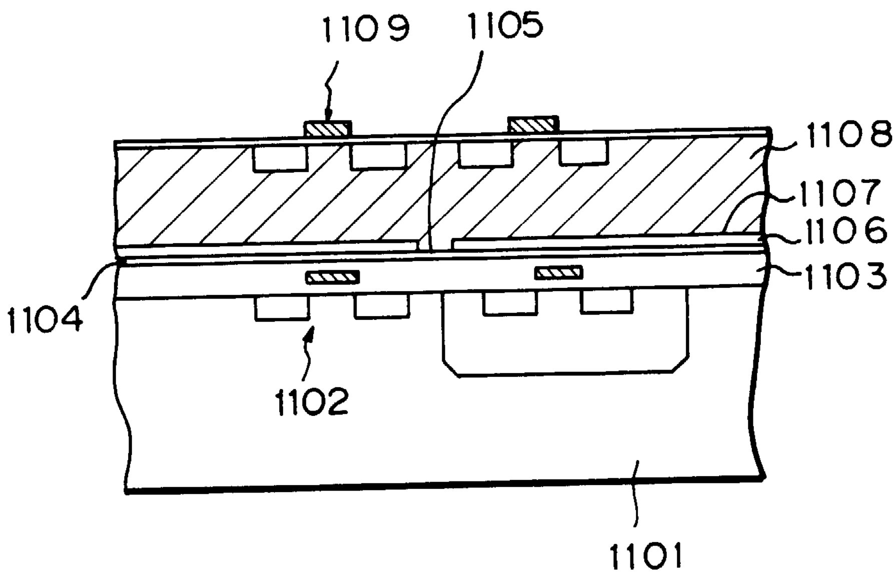

Fig. 12

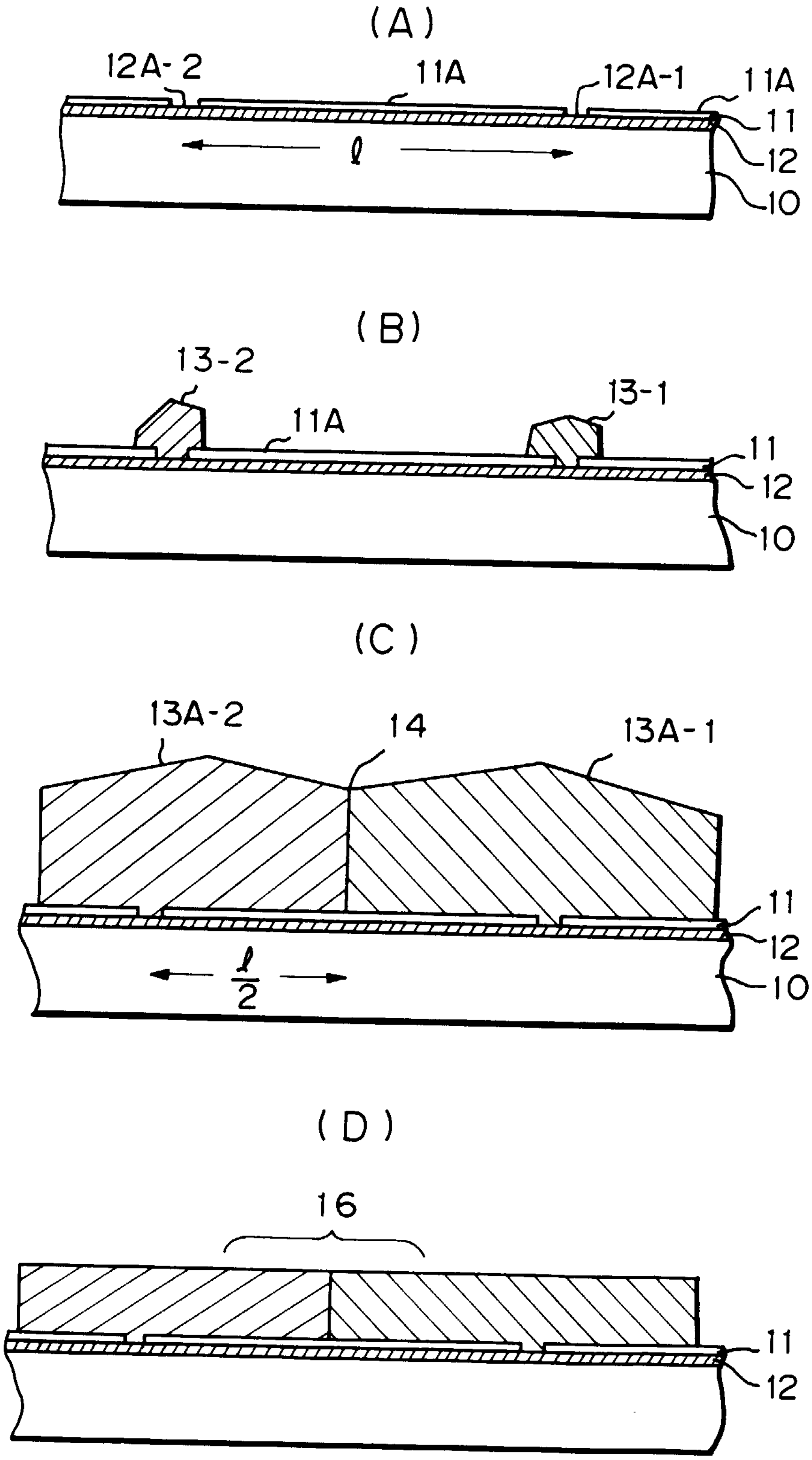
(A)
12A-2
11A
12A-1
11A
11
12
10
ℓ
(B)
13-2
11A
13-1
11
12
10
(C)
13A-2
14
13A-1
11
12
10
ℓ/2
(D)
16
11
12

*Fig. 13*

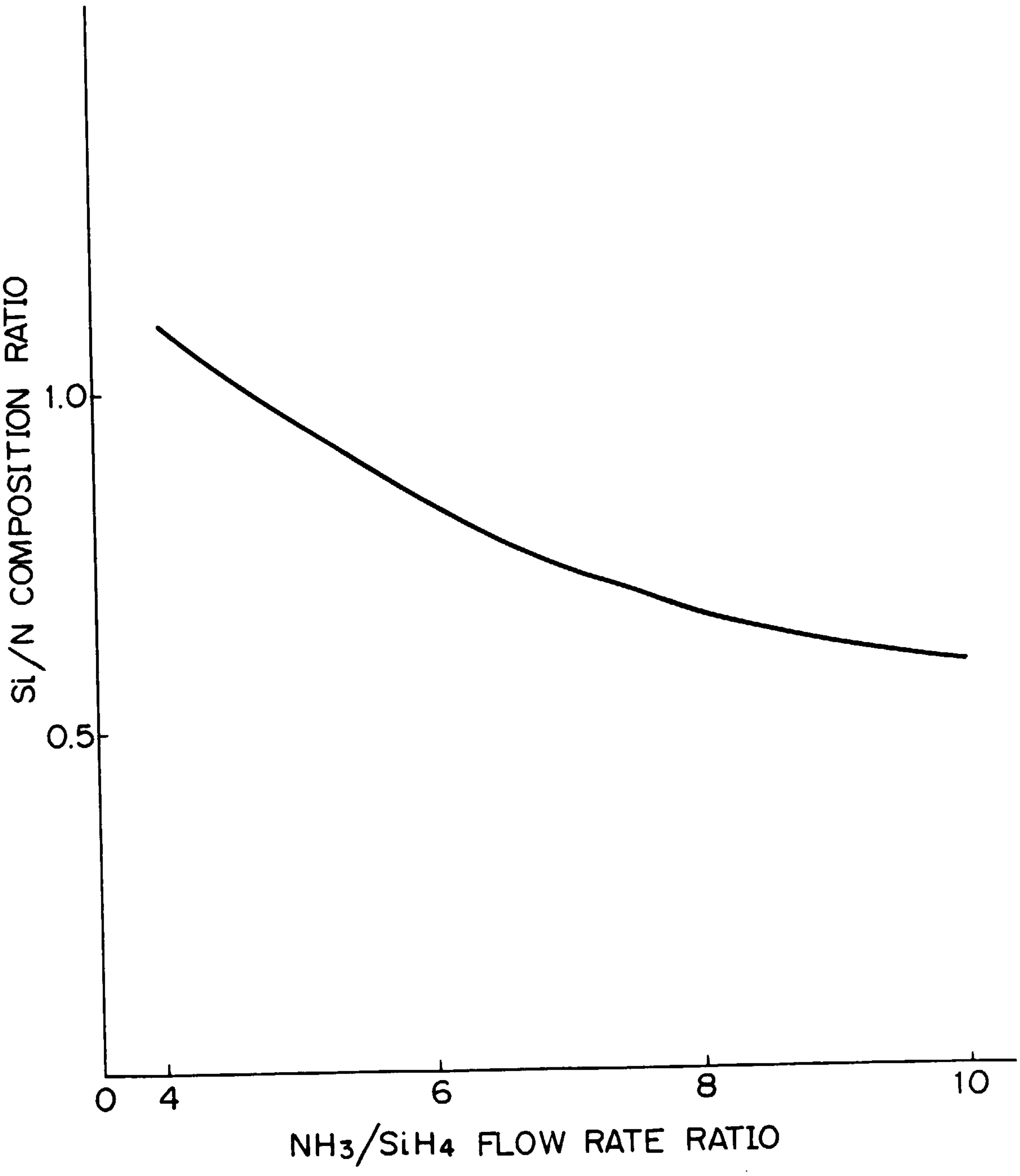

Fig. 14

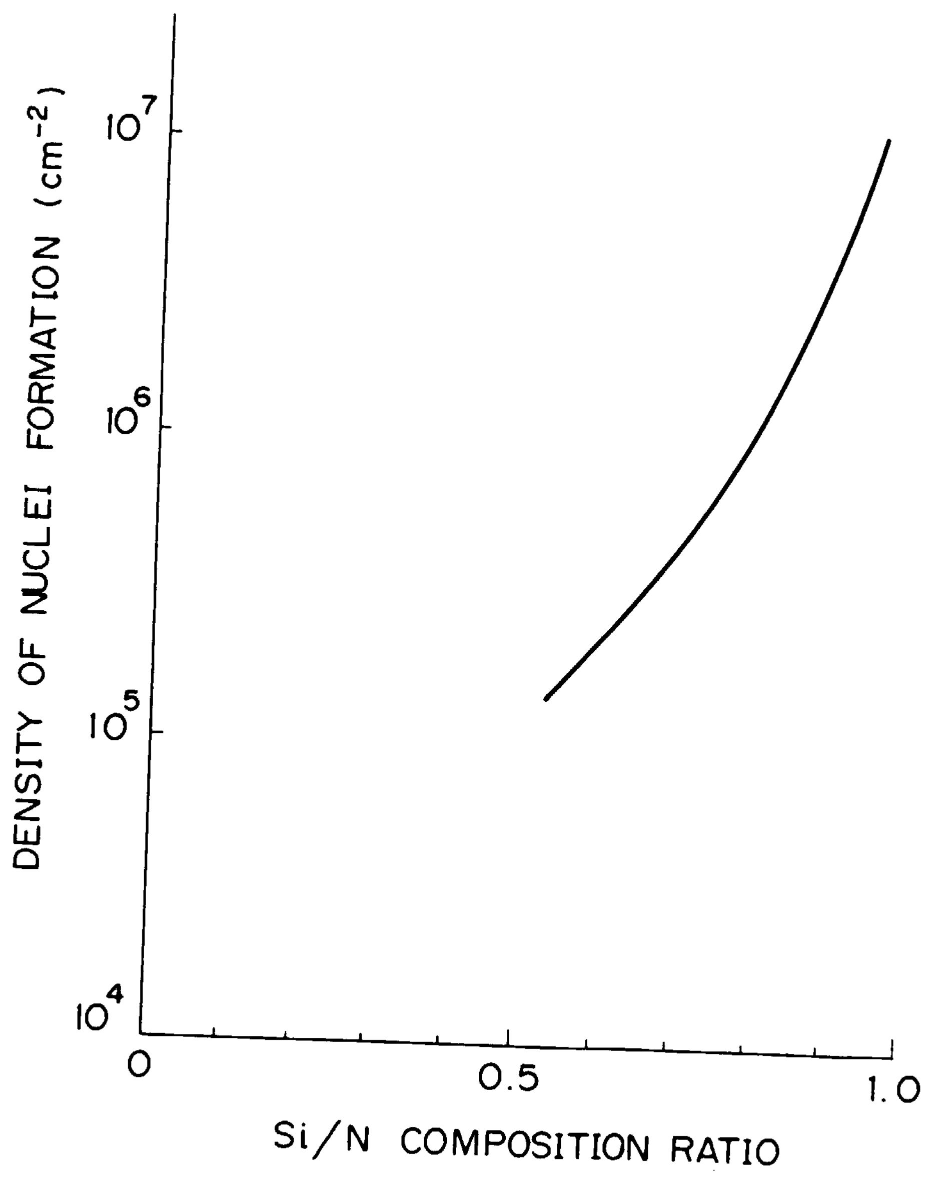
DENSITY OF NUCLEI FORMATION (cm$^{-2}$)
$10^7$
$10^6$
$10^5$
$10^4$
0
0.5
1.0
Si/N COMPOSITION RATIO

Fig. 15

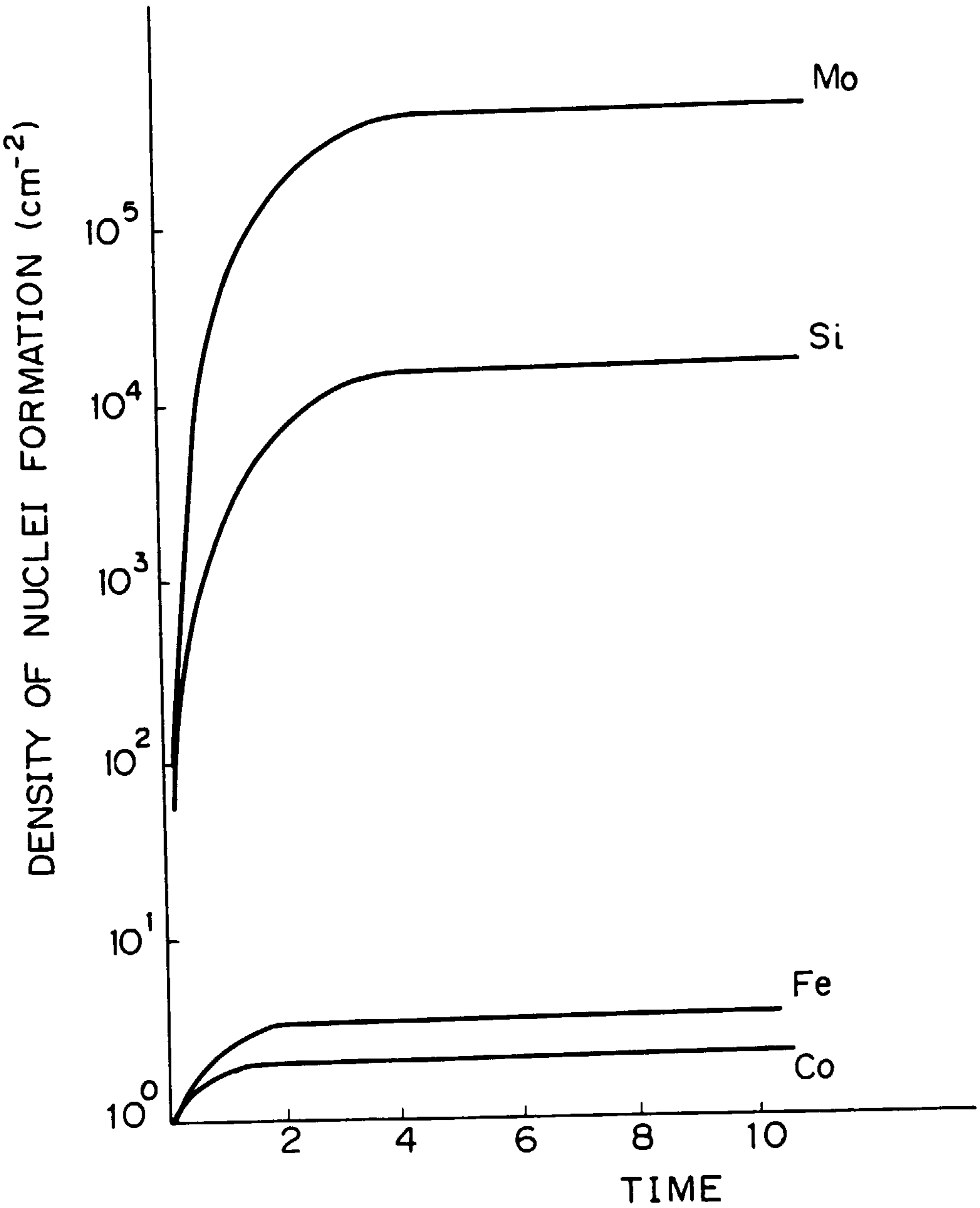
DENSITY OF NUCLEI FORMATION ($cm^{-2}$)
$10^5$
$10^4$
$10^3$
$10^2$
$10^1$
$10^0$
Mo
Si
Fe
Co
2
4
6
8
10
TIME